# EUROPEAN PATENT SPECIFICATION

(11) **EP 0 596 440 B1**
(45) Date of publication and mention of the grant of the patent: **16.07.1997**
(21) Application number: 93117677.0
(22) Date of filing: 02.11.1993
(51) Int. Cl.: H03J 1/00

(54) **Station selecting apparatus for digital modulation signal use**
Kanalwähler für digital modulierte Signale
Appareil sélecteur de stations pour signaux modulés numériquement

(30) Priority: 02.11.1992 JP 294100/92; 02.11.1992 JP 294101/92; 02.11.1992 JP 294102/92
(43) Date of publication of application: 11.05.1994
(73) Proprietor: Matsushita Electric Industrial Co., Ltd., Kadoma-shi Osaka-fu, 571 (JP)
(72) Inventor: Saka, Hiroshi, Katano-shi, Osaka-fu 576 (JP); Urata, Kazunao, Tondabayashi-shi, Osaka-fu 584 (JP)
(74) Representative: Eisenführ, Speiser & Partner

(56) References cited:
- EP-A- 0 441 593
- US-A- 4 339 725
- PATENT ABSTRACTS OF JAPAN vol. 8, no. 111 (E-246)(1548) 24 May 1984 & JP-A-59 027 626 (PIONEER K.K.) 14 February 1984

## Description

### BACKGROUND OF THE INVENTION

The present invention generally relates to a station selecting apparatus in a case where a modulation signal continued in a carrier phase of an AM modulation system FM modulation signal, a MSK modulation signal and so on and a digital modulation signal except for it exist at the same time in different frequency area or channel frequency during the signal reception, and more particularly, to a station selecting apparatus for stabilizing a frequency of a digital modulation signal to be inputted to a digital demodulator in accordance with frequency information to be obtained at a demodulating process after channel selection of continued demodulation signal of the carrier phase.

At present a FM modulation system is generally used for a modulation system of satellite broadcasting. Satellite digital voice broadcasting operation by a MSK modulation system is also realized. Recently, a satellite digital broadcasting operation by digital modulation system of QPSK or the like is also examined. In the future, a satellite broadcasting operation where a FM modulation system is mixed with a digital modulation system is considered.

At present, an AM modulation system is used for a modulation system in a ground broadcasting operation. Recently, a ground digital broadcasting by a digital modulation system of multi-value QAM or the like is also examined.

Generally there is a synchronizing detection system in a method of demodulating digitally modulated signals. In the synchronizing detection system, a PLL circuit is required for obtaining reproducing carriers synchronized in phase with the carriers of the digitally modulated signals. In order to improve the characteristics of the digital demodulating circuit, a frequency leading-in range of the PLL circuit is narrowed.

It is required to be stabilized so that the central frequency of the digital modulation signal to be inputted into the digital demodulating circuit may stay within the frequency leading-in range of the PLL circuit for carrier reproduction use in the carrier reproduction.

In the satellite broadcasting receiver, a station frequency of the BS converter can be drifted by approximately ± several MHz. A method of compulsorily sweeping an oscillation frequency of VCO by a frequency sweeping circuit for synchronizing leading-in use provided with a voltage control oscillator (hereinafter referred to as VCO) when the digital modulation digital is converted in frequency into intermediate frequency signal (hereinafter referred to as IF signal) is used for the drift absorbing means.

Even in the digital modulation system, there is a big difference in a method of absorbing the frequency drift of the carrier in a digital modulation system and so on such as a QPSK modulation system or the like not continued in the carrier phase with a MSK modulation system or the like continued in a carrier phase. In a MSK modulation system or the like continued in the carrier phase, an average value AFC system can be adapted, and the absorption of the frequency drift of the carrier is easier to effect. In the QPSK modulation, the average value AFC system cannot be not adapted as the carrier phase is not continued. In the QPSK modulation system, the oscillation frequency of the VCO is forced to be swept in the frequency sweeping circuit for synchronizing leading-in use provided with a VCO and also, the sweeping frequency width is also required to be widely set to be followed to the station transmitting frequency drift of the BS converter. (Fig. 13) shows a station selecting circuit for conventional digital modulation signal use.

In (Fig. 13), a frequency converting circuit 121 converts in frequency the digital modulation signal into an IF signal. The IF signal is transmitted into a digital modulating circuit 122 and is demodulated, and a digital demodulation signal is outputted. The digital demodulating circuit 122 includes a carrier reproducing circuit 22 for reproducing the carrier.

A station selecting circuit 120 includes a VCO 123, a variable frequency divider 124, a reference oscillator 125, a phase comparator 126, a loop filter 127, a microprocessor 128. As the VCO 123 is varied in oscillation frequency by a control signal given from a microprocessor 128, the oscillation frequency is large varied by a station selecting information to be inputted into the microprocessor 128 and the local oscillation signal of the VCO 123 is inputted into a frequency varying circuit 121 and a variable frequency divider 124. The variable frequency 124 divides the local oscillation signal with a frequency dividing ratio set by a microprocessor 128. The frequency dividing output of the variable frequency divider 124 is given to a phase comparator 126. The phase comparator 126 compares the local oscillation signal divided in frequency by the variable frequency divider 124 and the phase of the reference frequency of the reference oscillator 125 so as to output the phase error signal. The phase error signal is smoothed by a loop filter 127 and is given as a control voltage for controlling the oscillation frequency.

The microprocessor 128 compulsorily varies the frequency dividing ratio of the variable frequency divider 124 with a frequency dividing ratio to be set in accordance with the station selecting information being provided being provided as the center so as to vary the oscillation of the VCO 123 into a step shape. When the carrier frequency of the IF signal approaches a frequency of a carrier reproducing circuit 22 and the carrier is reproduced in synchronization with the carrier frequency of the IF signal, the synchronizing detection signal is inputted into a microprocessor 128 from the digital demodulating circuit 122 so as to suspend the vibration of the frequency dividing ratio of the variable frequency divider 124.

When the frequency variation of the IF signal to be inputted to the digital demodulating circuit 122 is large in the station selecting circuit of the above described conventional digital modulation signal station selection circuit, the frequency sweeping width of the VCO 123 within the station selecting circuit 120 has to be made larger in order to have the frequency variation within the synchronizing leading-in range of the digital demodulating circuit 122. The sweeping time becomes longer and time to the synchronization is taken. As the synchronization leading-in operation is effected from the beginning for each of the station selecting operations, with a problem that the station selecting time is taken.

### SUMMARY OF THE INVENTION

Accordingly, the present invention has been developed with a view to substantially eliminating the above discussed drawbacks inherent in the prior art, and has for its essential object to stabilize the synchronization leading-in operation.

Another important object of the present invention is to shorten a station selecting time.

In accomplishing these and other objects, according to one preferred embodiment of the present invention, there is provided a station selecting apparatus, which is composed of a station selecting circuit, for carrier phase sequence modulation signal use, provided with a first frequency converting circuit for frequency-converting modulation signals continued in a carrier phase so as to output a first intermediate frequency signal, a first station selecting means, provided with a first voltage control oscillator for changing an oscillation frequency by station selecting information, and adapted to feed to the first frequency converting circuit the local oscillation signal of the first voltage controlling oscillator, a frequency information detecting means for detecting the frequency information of the first intermediate frequency signal, a first frequency controlling means for receiving frequency information obtained by the frequency information detecting means, finely adjusting the oscillation frequency of the first voltage controlling oscillator so that the frequency of the first intermediate frequency signal may stay within the given frequency range of the first intermediate frequency signal, and of a station selecting circuit, for digital modulation signal use, provided with a second frequency converting means for frequency-converting the digitally modulated digital modulation signal so as to output the second intermediate frequency, a second station selecting means provided with a second voltage controlling oscillator for changing the oscillation frequency by the station selecting information so as to feed to the second frequency converting circuit the local oscillation signal of the second voltage controlling oscillator, a second frequency controlling means for receiving a frequency information obtained by the frequency information detecting means, finely adjusting the oscillation frequency of the second voltage controlling oscillator so that the frequency of the second intermediate frequency signal may stay in the given frequency range.

When the first frequency controlling means sets the oscillation frequency of the first voltage control oscillator in accordance with the station selecting information of the modulation signal continued in the carrier phase in the station selecting apparatus of the above described construction, the modulation signal continued in the carrier phase to be inputted to the first frequency converting circuit is converted in frequency to the first intermediate frequency signal. The first frequency controlling means receives the frequency information obtained by the frequency information detecting means for detecting the frequency of the first intermediate frequency signal so as to finely adjust the oscillation frequency of the first voltage controlling oscillator so that the frequency of the first intermediate frequency signal may stay within a given frequency range. The frequency of the first intermediate frequency signal modulated by the modulation system continued in the carrier phase is stabilized.

When the second frequency controlling means sets the oscillation frequency of the second voltage controlling oscillator in accordance with the station selecting information of the digital modulation signal, the digital modulation signal to be inputted into the second frequency converting circuit is converted in frequency to the second intermediate frequency signal.

The second frequency controlling means receives the frequency information of the first intermediate frequency signal obtained by the frequency information detecting means so as to finely adjust the oscillation frequency of the second voltage controlling oscillator so that the frequency of the second intermediate frequency signal may stay within the given frequency range.

If the fine adjustment the same or almost the same as the fine adjustment of the oscillation frequency of the first voltage control oscillator by the first frequency control means is effected by the second frequency control means for receiving the frequency information of the first intermediate frequency signal obtained by the frequency information detecting means, as the modulation signal continued in the carrier phase and the digital modulation signal also receive by an intermediate propagation path the common frequency variation of the same inclination or the almost same inclination, so that the frequency of the first intermediate frequency signal may stay within the given frequency range, the frequency of the second intermediate frequency signal digitally modulated also stays within the given frequency range and is stabilized.

When the modulation signal continued in such carrier phase as FM modulation signal exists in accordance with the present invention, an AFC circuit is normally operated with respect to the modulation signal continued in the carrier phase where the frequency information is easily obtained, and the station selecting frequency shift of the digital modulation signal station selecting circuit is controlled by the frequency information data to he obtained by the AFC circuit. The frequency of IF signal to be inputted into the digital demodulation circuit is easy to be stabilized so that it may stay within a constant range around the optimum input frequency of the digital demodulation circuit, and the frequency of the IF signal can stay within the constant range narrower around the synchronizing leading-in frequency of the digital demodulating circuit with an effect that the station selecting time as well as the synchronizing leading-in time of the digital demodulating circuit are shortened.

### BRIEF DESCRIPTION OF THE DRAWINGS

These and other objects and features of the present invention will become apparent from the following description of the preferred embodiment thereof with reference to the accompanying drawings, in which;
Fig. 1 is a block diagram of a station selecting apparatus in a first embodiment of the present invention;
Fig. 2 is a block diagram of a station selecting apparatus in a second embodiment of the present invention;
Fig. 3 is a block diagram showing one example of a frequency detecting circuit in accordance with embodiments of Fig. 1 and Fig. 2 of the present invention;
Fig. 4 is a block diagram showing another example of a circuit detecting circuit in the embodiments of Fig. 1 and Fig. 2 of the present invention;
Fig. 5 is a block diagram of a station selecting apparatus in a third embodiment of the present invention;
Fig. 6 is a block diagram of a station selecting apparatus in a fourth embodiment of the present invention;
Fig. 7 is a diagram showing a frequency variation of an IF signal FM-modulated with respect to a C/N ratio when a C/N ratio data by a C/N detecting circuit in the embodiment of Fig. 5 and Fig. 6;
Fig. 8 is a block diagram of a station selecting apparatus in a fifth embodiment of the present invention;
Fig. 9 is a block diagram of a station selecting apparatus in a sixth embodiment of the present invention;
Fig. 10 is a block diagram showing one example of a frequency detecting circuit in embodiments of Fig. 8 and Fig. 9 of the present invention;
Fig. 11 is a block diagram of a station selecting apparatus in a seventh embodiment of the present invention;
Fig. 12 is a block diagram of a station selecting apparatus in a eighth embodiment of the present invention; and
Fig. 13 is a block diagram of a station selecting apparatus of a digital modulation signal in a conventional embodiment.

### DETAILED DESCRIPTION OF THE INVENTION

Before the description of the present invention proceeds, it is to be noted that like parts are designated by like reference numerals throughout the accompanying drawings.

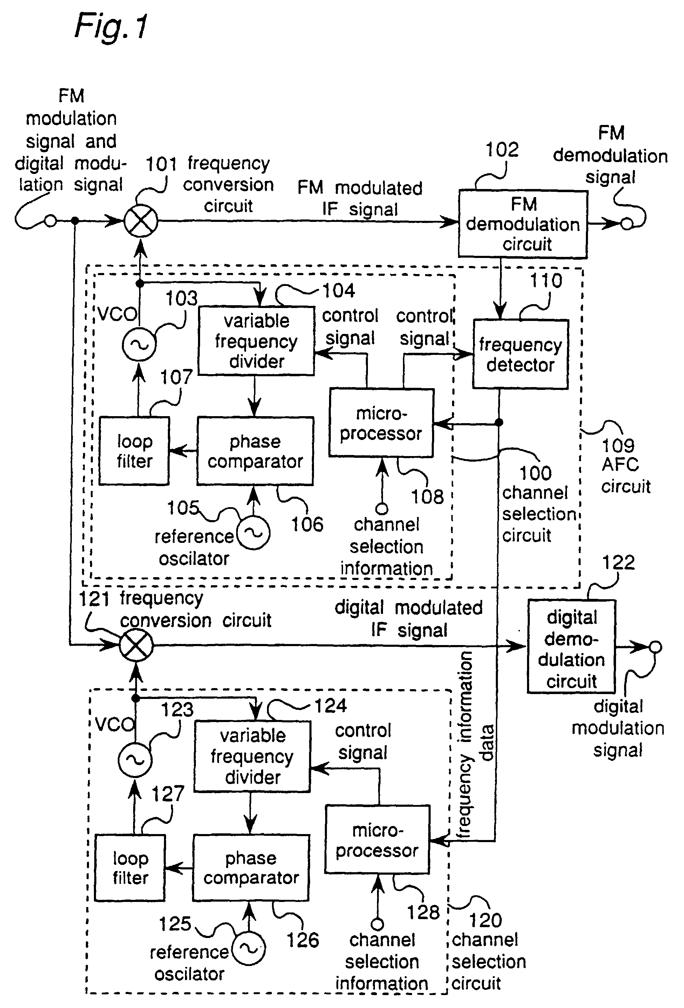

Fig. 1 is a station selecting apparatus in an embodiment of the present invention. A frequency converting circuit 101 frequency-converts FM modulation signals into IF signals. The IF signals are fed to a FM demodulating circuit 102 and is demodulated. A station selecting circuit 100 includes a VCO 103, a variable frequency divider 104, a reference oscillator 105, a phase comparator 106, a loop filter 107, a microprocessor 108. As the VCO 103 varies an oscillator frequency by a control signal to be given from a microprocessor 108, an oscillation frequency changes large by station selecting information to be inputted to the microprocessor 108 and the local oscillation signal of the VCO 103 is inputted into the frequency converting circuit 101 and a movable frequency divider 104. The variable frequency divider 104 divides the frequency with a frequency dividing ratio set by the microprocessor 108. The frequency division output of the variable frequency divider 104 is given to a phase comparator 106. The phase comparator 106 compares in phase with a local oscillation signal to be divided in frequency by a variable frequency divider 104 with a reference frequency of the reference oscillator 105 so as to output a phase error signal. The phase error signal is smoothed with a loop filter 107 and is given as a control voltage for controlling the oscillation frequency of the VCO 103.

An AFC circuit 109 is provided for stabilizing the central frequency of an IF signal to be outputted from the frequency converting circuit 101 and includes a frequency detecting circuit 110 and a station selecting circuit 100. A frequency detecting circuit 110 detects the frequency of an IF signal FM-modulated, controls the frequency dividing ratio of the variable frequency divider 104 in accordance with the frequency information data obtained by the frequency detecting circuit 110, finely adjusts the oscillation frequency of the VCO 103 and retains the frequency of the FM-modulated IF signal constant within the given range.

A frequency converting circuit 121 frequency-converts the digital modulation signal into an IF signal. The IF signal is fed to the digital demodulating circuit 122 and is demodulated.

A station selecting circuit 120 includes a VCO 123, a variable frequency divider 124, a reference oscillator 125, a phase comparator 126, a loop filter 127, a microprocessor 128. As the VCO 123 varies an oscillation frequency by a control signal to be given from the microprocessor 128, the oscillation frequency is changed large by station selecting information to be inputted to the microprocessor 128 and the local oscillation signal of the VCO 123 is inputted into the frequency converting circuit 121 and a variable frequency divider 124. A variable frequency divider 124 divides the local oscillation signal with a frequency dividing ratio set by a microprocessor 128. The frequency dividing output of the variable frequency divider 124 is given to a phase comparator 126. The phase comparator 126 compares in phase the local oscillation signal divided in frequency by a variable frequency divider 124 with the reference frequency of the reference oscillator 125 so as to output the phase error signal. The phase error signal is smoothed and is given as a control voltage for controlling the oscillation frequency of the VCO 123.

The frequency information data obtained by the frequency detecting circuit 110 is fed at the same time even to the microprocessor 128 so as to control the frequency dividing ratio of the variable frequency divider 124 to be included in the station selecting circuit 120 in accordance with the frequency information data, and the oscillation frequency of the VCO 123 is finely adjusted so as to maintain constant within the given range the frequency of the digitally modulated IF signal.

The operation of the station selecting apparatus in the embodiment of Fig. 1 will be described hereinafter. When the station selecting information where a FM modulation signal exists is inputted to a microprocessor 108, the frequency dividing ratio corresponding to the station selecting information is set in the variable frequency divider 104. The VCO 103 feeds to the frequency converting circuit 101 the local oscillating signal corresponding to the station selecting information. The frequency converting circuit 101 converts the FM converting signal into an IF signal.

The frequency detecting circuit 110 is controlled by a microprocessor 108 so as to detect the frequency of the FM-modulated IF signal. The frequency information data is proposed to the microprocessor 108. The microprocessor 108 calculates, in accordance with the frequency information data, the frequency error portion between the frequency of the FM-modulated IF signal and the optimum input frequency of the IF signal to be inputted to the FM demodulating circuit 102 so as to finely adjust the frequency dividing ratio of the variable frequency divider 104 with respect to the frequency error portion so that the frequency of the FM- modulated IF signal may stay within the given range around the optimum input frequency of the FM demodulating circuit 102.

When the station selecting information where the digital modulating signal exists is inputted to the microprocessor 128, the frequency dividing ratio corresponding to the station selecting information is set to the variable frequency divider 124 so that the VCO 123 feeds the local oscillation signal corresponding to the station selecting information to the frequency converting circuit 121. The frequency converting circuit 121 converts the digital modulation signal into an IF signal.

The frequency information data of the FM modulation signal obtained by the frequency detecting circuit 110 is fed at the same time even to the microprocessor 128. The microprocessor 128 calculates the frequency error portion between the frequency of the digitally modulated IF signal and the optimum input frequency of the digital demodulating circuit 122, finely adjusts the frequency dividing ratio of the variable frequency divider 124 in accordance with the frequency error portion. The frequency of the IF signal to be inputted to the digital demodulating circuit 122 is stabilized so that it may stay within the given range around the optimum input frequency.

The information of the IF signal to be inputted to the digital demodulating circuit 122 can be stabilized so that it may stay within a constant range around the optimum input frequency in accordance with the frequency information data of the FM modulation signal to be obtained by the frequency detecting circuit 110, because both the FM modulation signal and the digital modulation signal are received in the common frequency variation of the same or almost the same inclination by an intermediate propagation path and the frequency variation the frequency of the FM modulation signal receives on an intermediate propagation path is equal or almost equal to the frequency variation amount the frequency of the digital modulation signal receives on the intermediate propagation path so that the frequency difference between the FM modulation signal and the digital modulation signal is equal to the frequency difference between the nominal channels.

The embodiment of the present invention of the present invention is a method of controlling the oscillation frequency of a VCO 123 by the frequency information data to be obtained by the AFC circuit 109 with the AFC circuit 109 being normally operated with respect to the FM modulation signal to be easily constituted by the AFC circuit 109, and reducing the shift from the optimum input frequency of the digitally modulated IF signal. The frequency of the IF signal to be inputted to the digital demodulation circuit 122 can be easily stabilized so that it may stay within a constant range around the optimum input frequency, and the frequency of the IF signal stays within relatively narrower constant range around the synchronizing leading-in frequency of the digital demodulation circuit 122 so that the station selecting time as well as the synchronizing leading-in time of the digital demodulation circuit 122 is also shortened.

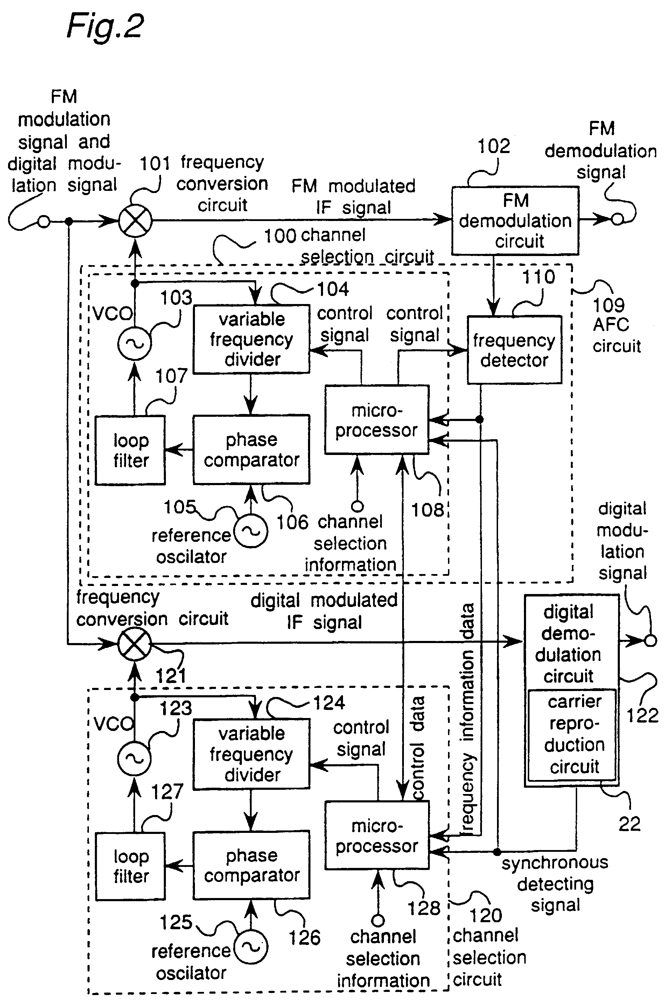

Fig. 2 is a station selecting apparatus in another embodiment by the present invention. The same reference numerals are given to the same locations as those of Fig. 1 for description thereof. The digital demodulating circuit 122 includes a carrier reproducing circuit 22 for reproducing the carrier. When the carrier reproducing operation is effected by the carrier reproducing circuit 22, synchronizing detecting signals are fed to microprocessors 108, 128 from the digital demodulating circuit 122. In the embodiment of Fig. 1, the oscillation frequency of the VCO 103, 123 are controlled in accordance with the only the frequency information data obtained by the frequency detecting circuit 110, but the embodiment of Fig. 2 is different from the embodiment of Fig. 1 in that the oscillation frequency of the VCOs 103, 123 is controlled even by a synchronizing detecting signal to be obtained by the digital demodulating circuit 122 except for the frequency information data.

The operation of the station selecting apparatus will be described by the embodiment of Fig. 2. When the station selecting information where the FM modulation signal exists is inputted to the microprocessor 108, and the frequency dividing ratio corresponding to the station selecting information is set to the movable frequency divider 104. The VCO 103 feeds the local oscillation signal corresponding to the station selecting information to the frequency converting circuit 101. The frequency converting circuit 101 converts the FM modulations signal to the IF signal.

The frequency detecting circuit 110 is controlled by the microprocessor 108, and the frequency of the FM modulated IF signal is detected to feed the frequency information data to the microprocessor 108. The microprocessor 108 calculates the frequency error portion between the frequency of the FM modulated IF signal and the optimum input frequency of the IF signal to be inputted to the FM demodulating circulation in accordance with the frequency information data so as to finely adjust the frequency dividing ratio of the variable frequency divider 104 in accordance with the frequency error portion and stabilizes so that the frequency of the FM modulated IF signal may stay within the given range around the optimum input frequency of the FM demodulating circuit 102.

When the station selecting information where digital modulation signals exist is inputted into the microprocessor 128, a frequency dividing ratio is set in the variable frequency divider 124 in accordance with the frequency information and the frequency information data obtained by the frequency detecting circuit 110, and the VCO 123 feeds the local oscillation signal corresponding to the station selecting information to the frequency converting circuit 121. The frequency converting circuit 121 converts to the IF signal the digital modulation signal. The frequency of the IF signal to be inputted to the digital demodulation circuit 122 is stabilized so that it may stay within a given range around the optimum input frequency of the digital demodulating circuit 122.

The frequency of the IF signal to be inputted to the digital demodulation circuit 122 stays within the constant range around the optimum input frequency, and at the same time, the microprocessor 128 forces the frequency dividing ratio of the variable frequency divider 124 to be varied around the set frequency dividing ratio so that the oscillation frequency of the VCO 123 is varied into a step shape. The frequency of the IF signal approaches the frequency of the carrier reproducing circuit 22. When the carrier reproduction is effected by a carrier reproducing circuit 22, the synchronizing detecting signal is inputted to the microprocessor 128 from the digital demodulation circuit 128 so as to stop the variation of the frequency dividing ratio of the variable frequency divider 124.

When the FM modulation signal does not exist, the first station selecting information where the digital modulation signal exists is inputted to the microprocessor 128 so as to, first, set the frequency dividing ratio corresponding to the selecting station information to the variable frequency divider 124, and the VCO 123 feeds to the frequency converting circuit 121 the local oscillation signal corresponding to the station selecting information. The frequency converting circuit 121 converts into the IF signal the digital modulating signal. The microprocessor 128 forces the frequency dividing ratio of the variable frequency divider 124 to be varied around the frequency dividing ratio to be set in accordance to the first station selecting information for varying the oscillation frequency of the VCO 123 into a step shape. The variable range of the frequency dividing ratio of the variable frequency divider 124 is set so that the frequency of the digital modulation signal may catch sufficiently the frequency modulation amount the frequency of the digital modulation signal receives on an intermediate propagation path. When the frequency of the IF signal approaches the frequency of the carrier reproducing circuit 22 so as to effect the carrier reproducing operation, the synchronizing detection signal is inputted to the microprocessor 128 from the digital demodulating circuit 22 for suspending the variation of the frequency dividing ratio of the variable frequency divider 124.

On the side of the microprocessor 108, the frequency dividing ratio data of the variable frequency divider 124 is received from the side of the microprocessor 128 while the synchronizing detection signal is outputted from the digital demodulating circuit 122. On the side of the microprocessor 108, the frequency dividing ratio of the variable frequency divider 124 at the carrier reproducing time, instead of the frequency information data to be obtained by the frequency detecting circuit 110, is preserved while being normally renewed. When the synchronization of the carrier reproducing circuit 22 is disconnected, the frequency dividing ratio of the variable frequency divider 124 is, first, set in accordance with the newest frequency dividing ratio of the variable frequency divider 124 which is preserved on the microprocessor 108.

The microprocessor 128 forces the frequency dividing ratio of the variable frequency divider 124 around the set frequency dividing ratio to vary the oscillation frequency of the VCO 123 into a step shape. As the frequency of the digitally modulated IF signal is already retained constant within a given range and is stabilized, the variable range of the frequency dividing ratio of the variable frequency divider 124 is sufficient enough to make up for the frequency variation of the stabilized IF signal. When the frequency of the IF signal approaches the frequency of the carrier reproducing circuit 22 so as to effect the carrier reproduction again, the synchronizing detection signal is inputted into the microprocessor 128 from the digital demodulating circuit 122 for suspending the variation of the frequency dividing ratio of the variable frequency divider.

The embodiment of the present invention in Fig. 2 is a method of normally operating the AFC circuit 109 with respect to the FM modulation signal the frequency can easily detect when the FM modulation signal exits, controlling the frequency shift of the station selecting circuit 120 for the digital modulation signal use by the frequency information data to be obtained by the AFC circuit 109, and reducing the shift from the optimum input frequency of the digital demodulating circuit 122 of the frequency of the IF signal. The IF signal to be inputted to the digital demodulating circuit 122 can be easily stabilized so that it may stay within a constant range around the optimum input frequency. As the frequency of the IF signal stays within a relatively narrow constant range around the synchronizing leading-in frequency of the digital demodulating circuit 122 so that both the synchronizing leading-in time of the digital demodulating circuit 122 and the station selecting time can be also shortened.

When the FM modulation signal does not exist, time is taken to effect a synchronizing operation immediately after the first station electing information where the digital modulation signal exists has been inputted. When the carrier reproduction is once established, the frequency dividing ratio of the variable frequency divider 124 when the carrier reproducing operation of the digital demodulating circuit 122 is effected is fed onto the side of the microprocessor 108 from the microprocessor 128 so as to preserve the frequency dividing ratio data of the variable frequency divider 124 at the carrier reproduction time while it is normally being renewed on the side of the microprocessor 108. If the synchronization of the carrier reproducing circuit 22 is shifted, the frequency dividing ratio of the movable frequency divider 124 is first set in accordance with the newest frequency division data of the variable frequency divider 124 which is preserved on the microprocessor 108 at the synchronizing time. The microprocessor 128 forces the frequency dividing ratio of the variable frequency divider 124 to be varied around the set frequency dividing ratio so as to vary the oscillation frequency of the VCO 123 into a step shape. As the frequency of the digitally modulated IF signal is already retained constantly within a given range, the variable range when the frequency dividing ratio of the variable frequency divider 124 is forced to be varied is sufficient enough to make up for the frequency variation of the frequency of the IF signal already stabilized. Both the synchronizing leading-in time and the station selecting time are shortened.

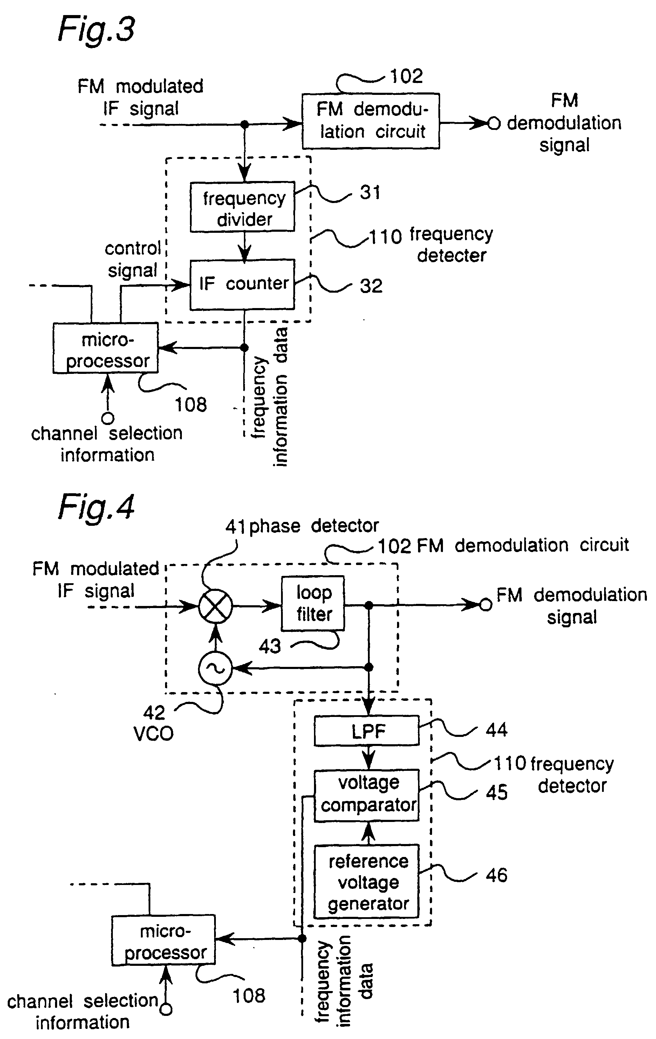

Fig. 3 a view showing one example of a frequency detecting circuit 110 shown in Fig. 1 and Fig. 2. The frequency detecting circuit 110 includes a frequency divider 31 and an IF counter 32. The frequency divider 31 divides the FM-modulated IF signal. The IF counter 32 counts the frequency of the IF signal divided by the frequency divider 31. The microprocessor 108 controls the IF counter 32 so that the frequency dividing signal frequency of the IF signal divided by the frequency divider 31 may be counted for a constant period by the IF counter 32 so as to receive as a frequency information data a calculated value counted by an IF counter 32. The microprocessor 108 compares a received calculated value with a reference value set previously within the microprocessor 108. In accordance with the comparison results, the frequency error portion between the frequency of the FM-modulated IF signal and the optimum input frequency of the FM demodulating circuit 102 is calculated. The frequency dividing ratio of the variable frequency divider 104 is finely adjusted in accordance with the frequency error portion and the frequency of the FM modulated IF signal is stabilized so that it may stay within a constant range around the optimum input frequency.

Fig. 4 is a view showing another embodiment of the frequency detecting circuit shown in Fig. 1 and Fig. 2. The FM demodulating circuit 102 includes the phase detector 41, the VCO 42 and the loop filter 43 by the FM demodulating circuit by a PLL. The frequency detecting circuit 110 includes a low-pass filter 44 (referred to as LPF), a voltage comparator 45 and a reference voltage generator 46.

A FM demodulation signal which is an output signal of the loop filter 43 is extracted in direct current component by the LPF 44. The voltage comparator 45 compares the direct current component extracted by the LPF 44 with the reference voltage of the reference voltage generator 46 so as to output the voltage error signal as frequency information data. As the direct current component of the FM demodulation signal corresponds to the particular frequency of the FM modulation signal in the FM modulation signal, the voltage error signal of the voltage comparator 45 corresponds by 1 to 1 with the frequency information of the FM-modulated IF signal. The microprocessor 108 receives the voltage error signal as the frequency information data of the FM-modulated IF signal. The microprocessor 108 calculates the frequency error portion between the frequency of the FM-modulated IF signal and the optimum input frequency of the FM demodulating circuit 102 in accordance with the size of the received voltage error signal, finely adjusts the frequency dividing ratio of the variable frequency divider 104 in accordance with the frequency error portion, and the frequency of the FM-modulated IF signal is stabilized so that it may sty within a constant range around the optimum input frequency.

Although the reference voltage generator 46 is constructed independently of the microprocessor 108 in the embodiment of the Fig. 4, the reference voltage of the reference voltage generator 46 may be constructed to be controlled by the microprocessor 108.

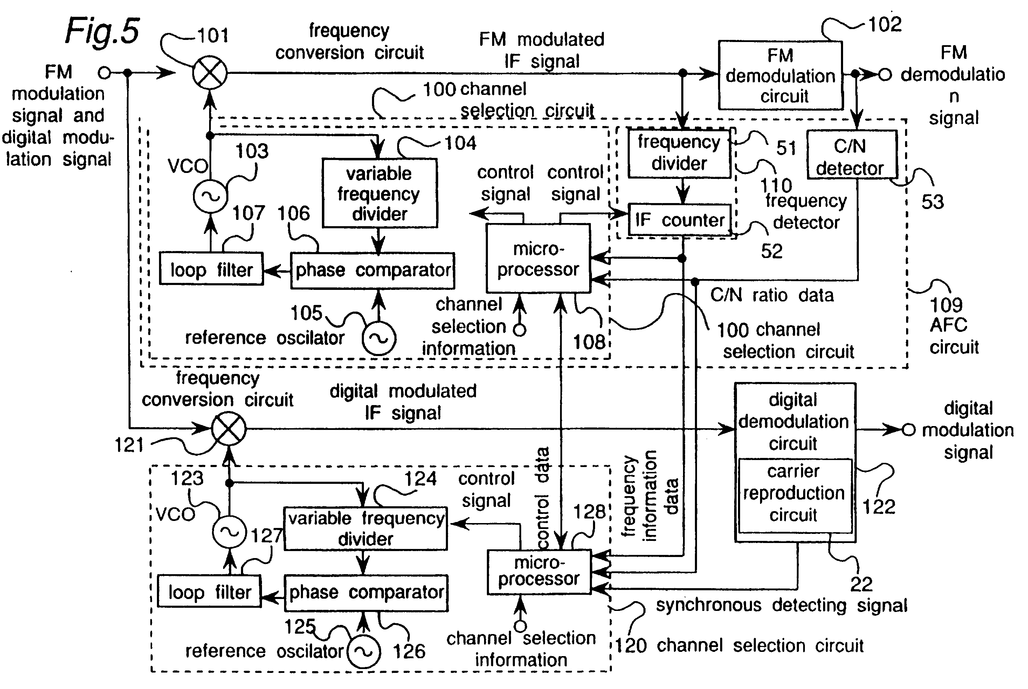

Fig. 5 is a station selecting apparatus in a still another embodiment by the present invention. It will be described with the same reference numerals to the same locations as in Fig. 2. The AFC circuit 109 is provided for stabilizing the central frequency of the IF signal outputted from the frequency converting circuit 101 and includes a frequency divider 51, an IF counter 52, a station selecting circuit 100 and a C/N detecting circuit 53. The frequency divider 51 divides the FM-modulated IF signal and the IF counter 52 counts the frequency of the IF signal divided by the frequency divider 51.

The operation of the station selecting apparatus by the embodiment of Fig. 5 will be described hereinafter. When the station selecting information where FM modulation signal exists is inputted to the microprocessor 108, the frequency dividing ratio corresponding to the station selecting information is set in the variable frequency divider 104 and the VCO 103 feeds the local oscillation signal corresponding to the station selecting information to the frequency converting circuit 101. The frequency converting circuit 101 converts the FM modulation signal to the IF signal. The IF signal is fed to the FM demodulating circuit 102 and is demodulated.

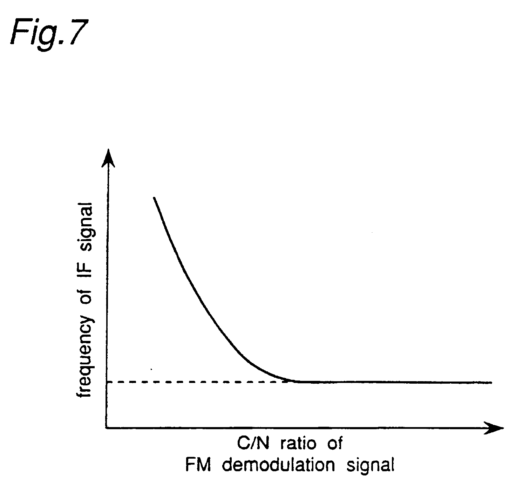

The microprocessor 108 controls the IF counter 52 so that the frequency dividing signal frequency of the IF signal divided by the frequency diver 51 may be counted for a given time period by the IF counter 52 so as to receive the calculation value data calculated by the IF counter 52 and also, the C/N ratio data obtained by the C/N detecting circuit 53. The microprocessor 108 sets the reference value data to be compared with the calculation value data counted by the IF counter 52 in accordance with the received C/N ratio data and also, compares the received calculation value data with the set reference value data. The frequency error portion between the frequency of the FM-modulated IF signal and the optimum input frequency of the IF signal to be inputted to the FM demodulating circuit 102 in accordance with comparison result. The frequency dividing ratio of the variable frequency divider 104 is finely adjusted in accordance with the frequency error portion. The frequency of the FM modulated IF signal is stabilized so that it may stay within a constant range around the optimum input frequency of the FM demodulating circuit 102. The reason why the reference value data is set in accordance with the size of the C/N ratio data obtained by the C/N detecting circuit 53 will be given in the description of Fig. 7.

When the station selecting information where the digital modulation signal exists is inputted to the microprocessor 128, the frequency dividing ratio corresponding to the station selecting information is set in the variable frequency divider 124 by the microprocessor 128 and the VCO 123 feeds the local oscillation signal corresponding to the station selecting information to the frequency converting circuit 121. The frequency converting circuit 121 converts the digital modulation signal to the IF signal.

The C/N ratio data detected by the C/N detecting circuit 53 and the calculation value data calculated by the IF counter 52 are fed to the microprocessor 128. The microprocessor 128 newly sets the reference value data to be compared with the calculation value data to be fed from the IF counter 52 in accordance with the size of the C/N ratio data and also, compares the calculation value data fed from the IF counter 52 with the reference value data. The frequency error portion between the frequency of the digitally modulated IF signal and the optimum input frequency of the digital demodulating circuit 122 is calculated in accordance with the comparison result. The frequency dividing ratio of the variable frequency divider 124 is controlled in accordance with the frequency error portion so as to finely adjust the oscillation frequency of the VCO 123 so as to keep constant the frequency of the digitally modulated IF signal within the given range and the frequency of the IF signal to be inputted to the digital demodulating circuit 122 is stabilized so that it may stay within a constant range around the maximum input frequency.

When the IF signal to be inputted to the digital demodulating circuit 122 stays within the constant range around the optimum input frequency, the microprocessor 128 forces the frequency dividing ratio of the variable frequency divider 124 to vary around the set frequency division ratio so as to vary the oscillation frequency of the VCO 123 into a step shape. When the frequency of the IF signal approaches the frequency of the carrier reproducing circuit 22 to effect the carrier reproducing operation, the synchronization detecting signal is inputted to the microprocessor 128 from the digital demodulating circuit 122 so as to suspend the variation of the frequency division ratio of the variable frequency divider 124.

In the embodiment of the Fig. 5, the AFC circuit 109 is normally operated with respect to the FM modulation signal the AFC circuit 109 can generate easily. The oscillation frequency of the VCO 123 is controlled by the frequency information data of the FM modulation signal to be obtained by the AFC circuit 109 so as to reduce the shift from the optimum input frequency of the digital modulation signal to be inputted to the digital demodulating circuit 122. Thereafter, as the method is a method of compulsorily varying the frequency of the VCO 123 so as to causing the synchronizing leading-in operation of the digital demodulating circuit 122, the IF signal to be inputted to the digital demodulating circuit 122 can be easily stabilized so that it may stay within the relatively narrow constant range around the optimum input frequency and the frequency of the IF signal may stay within the relatively narrow constant range around the synchronizing leading-in frequency of the digital demodulating circuit 122, so that both the synchronizing leading-in time of the digital demodulating circuit 122 and the station selecting time are shortened. As it is a method of improving the precision of the frequency information data of the FM modulation signal in accordance with the C/N ratio data obtained by the C/N detecting circuit 53, the frequency information data of the FM modulations signal can be obtained with precision even at the low C/N time with a similar effect even in the low C/N time.

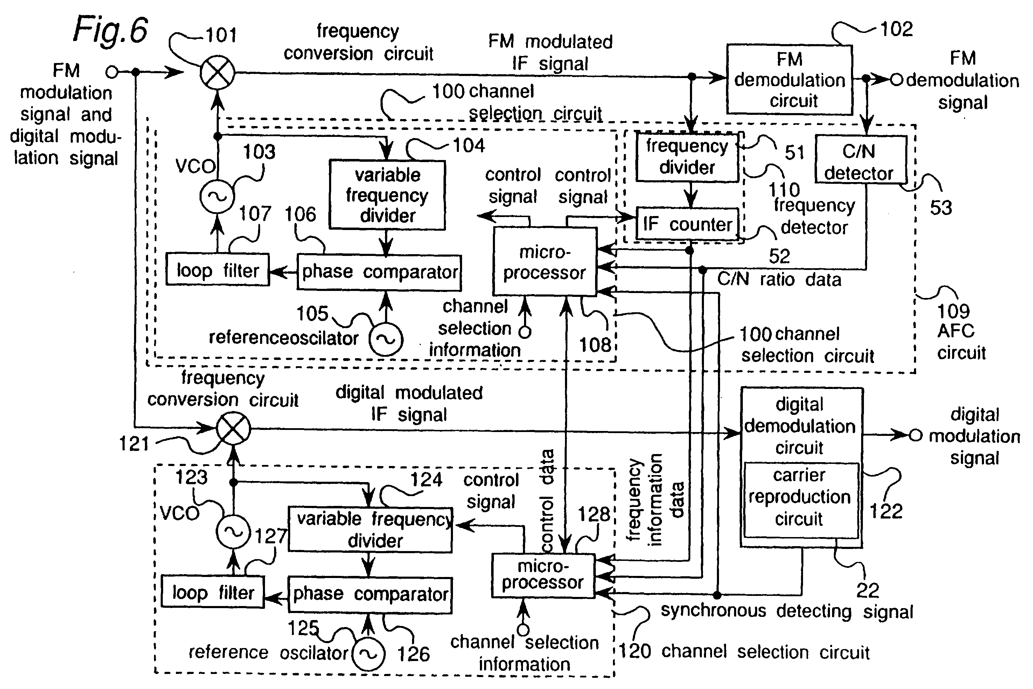

Fig. 6 is a station selecting apparatus in a further embodiment by the present invention. It will be described with the same reference numerals being given to the same locations as in Fig. 5. Although the synchronizing detection signal to be obtained by the digital demodulating circuit 122 is used only in the controlling operation of the oscillation frequency of the VCO 123 in the embodiment of Fig. 5, the embodiment of Fig. 6 is different from Fig. 5 in that it is used in the control of the oscillation frequency of not only the VCO 123, but also the VCO 103.

The operation of the station selecting apparatus by the embodiment of Fig. 6 will be described hereinafter. When the station selecting information where FM modulating signal exists is inputted to the microprocessor 108, the frequency dividing ratio corresponding to the station selecting information by the microprocessor 108 is set in the variable frequency divider 104 so as to feed the local oscillation signal corresponding to the station selecting information to the frequency converting circuit 101. The frequency converting circuit 101 converts the FM modulation signal to the IF signal. The IF signal is fed to the FM demodulating circuit 102 and is demodulated.

The microprocessor 108 controls the IF counter 52 so that the frequency dividing signal frequency of the IF signal divided by the frequency divider 51 may be counted for a constant period of time by the IF counter 52 so as to receive the calculation value data counted by the IF counter 52 and also, receives the C/N ratio data obtained by the C/N detecting circuit 53. The microprocessor 108 sets the reference value data to be compared with the calculation value to be counted by the IF counter 52 in accordance with the size of the received C/N ratio data, and also, compares the received calculation value data with the set reference value data. The frequency error portion between the frequency of the FM modulated IF signal and the optimum input frequency of the IF signal to be inputted to the FM demodulating circuit 102 is calculated. The frequency dividing ratio of the variable frequency divider 104 is finely calculated in accordance with the frequency error portion. The frequency of the FM modulated IF signal is stabilized so that it may stay within the constant range around the optimum input frequency of the FM demodulating circuit 102. The reason why the reference value data is set in accordance with the size of the C/N ratio data obtained by the C/N detecting circuit 53 will be described in Fig. 7.

When the station selecting information where the digital modulation signal exits is inputted to the microprocessor 128, the frequency division ratio corresponding to the station selecting information is set in the variable frequency divider 124, and the VCO 123 feeds to the frequency converting circuit 121 the local oscillation signal corresponding to the station selecting information. The frequency converting circuit 121 converts the digital modulation signal into the IF signal.

The C/N ratio data detected by the C/N detecting circuit 53 and the calculation value data counted by the IF counter 52 are fed even to the microprocessor 128. The microprocessor 128 newly sets the reference value data to be compared with the calculation value data to be fed from the IF counter 52 and also, compares with the calculation value data fed from the IF counter 52 with the reference value data. The reference error portion between the frequency of the digitally modulated IF signal and the optimum input frequency of the digital demodulating circuit 122 is calculated in accordance with the comparison result. The frequency dividing ratio of the variable frequency divider 124 is controlled in accordance with the frequency error portion so as to finely adjust the oscillation frequency of the VCO 123 and retain constantly the frequency of the digitally modulated IF signal within the given range so that the frequency of the IF signal to be inputted to the digital demodulating circuit 122 is stabilized so that it may stay within the constant range around the optimum input frequency.

When the IF signal to be inputted to the digital demodulating circuit 122 stays within the constant range around the optimum input frequency, the microprocessor 128 compulsorily varies the frequency dividing ratio of the variable frequency divider 124 around the set frequency dividing ratio so as to convert the oscillation frequency of the VCO 123 into the step shape. The frequency of the IF signal approaches the frequency of the carrier reproducing circuit 22 so as to effect a carrier reproducing operation, the synchronizing detection signal is inputted to the microprocessor 128 from the digital demodulating circuit 122 so as to suspend the variation of the frequency dividing ratio of the variable frequency divider 124.

When the FM modulation signal does not exist, the first station selecting information where the digital modulation signal exists is inputted to the microprocessor 128 so as to, first, set the frequency dividing ratio corresponding to the station selecting information to the variable frequency divider 124 by the microprocessor 128, and the VCO 123 feeds to the frequency converting circuit 121 the local oscillation signal corresponding to the station selecting information. The frequency converting circuit 121 converts into the IF signal the digital modulating signal. The microprocessor 128 forces the frequency division ratio of the variable frequency divider 124 to vary around the frequency division ratio to be set in accordance with the first station selecting information for varying the oscillation frequency of the VCO 123 into a step shape. The variable range of the frequency division ratio of the variable frequency divider 124 is set so that the frequency of the digital modulation signal may catch sufficiently the frequency variation amount the frequency of the digital modulation signal receives on an intermediate propagation path. When the frequency of the IF signal approaches the frequency of the carrier reproducing circuit 22 so as to effect the carrier reproducing operation, the synchronizing detection signal is inputted to the microprocessor 128 from the digital demodulating circuit 22 for suspending the variation of the frequency division ratio of the variable frequency divider 124.

On the side of the microprocessor 108, the frequency division data of the variable frequency divider 124 is received from the side of the microprocessor 128 while the synchronizing detection signal is outputted from the digital demodulating circuit 122. On the side of the microprocessor 108, the frequency division ratio data of the variable frequency divider 124 at the carrier reproducing time, instead of the frequency information data of the FM modulated IF signal to be obtained by the AFC circuit 109, is preserved while being normally renewed. When the synchronization of the carrier reproducing circuit 22 is disconnected, the frequency division ratio of the variable frequency divider 124 within the station selecting circuit 120 is, fist, set in accordance with the newest frequency division ratio of the variable frequency divider 124 which is provided on the side of the microprocessor 108. The microprocessor 128 forces the frequency division ratio of the variable frequency divider 124 to vary around the set frequency division ratio so as to vary the oscillation frequency of the VCO 123 into a step shape. As the frequency of the digitally modulated IF signal is already retained constant within a given range and the variable range of the frequency division ratio of the variable frequency divider 124 is sufficient if it is enough to make up for the frequency variation of the stabilized IF signal. When the frequency of the IF signal approaches the frequency of the carrier reproducing circuit 22 so as to effect the carrier reproduction again, the synchronizing detection signal is inputted to the microprocessor 128 from the digital demodulating circuit 122 for suspending the variation of the frequency division ratio of the variable frequency divider.

In the embodiment of the present invention in Fig. 6, the AFC circuit 109 is normally operated with respect to the FM modulation signal the frequency can easily detect when the FM modulation signal exits. The frequency shift of the station selecting circuit 120 for the digital modulating signal use is controlled by the frequency information data to be obtained by the AFC circuit 109, and the shift from the optimum input frequency of the digital demodulation signal to be inputted to the digital demodulating circuit 122 is reduced. Thereafter, as the method is a method of compulsorily varying the frequency of the VCO 123 so as to causing the synchronizing leading-in operation of the digital demodulating circuit 122 to effect. The frequency of the IF signal to be inputted to the digital demodulating circuit 122 can be easily stabilized so that it may stay within the relatively narrow constant range around the optimum input frequency and the frequency of the IF signal may stay within the relatively narrow constant region around the synchronizing leading-in frequency of the digital demodulating circuit 122, so that both the synchronizing leading-in time of the digital demodulating circuit 122 and the station selecting time are shortened. As the method is a method of obtaining the precision of the frequency information data of the FM modulation signal in accordance with the C/N ratio data obtained by the C/N detecting circuit 53, the frequency information data of the FM modulations signal can be obtained with precision even at the low C/N time with an effect that both the synchronizing leading-in time and the station selecting time are shortened even in the low C/N time.

When the FM modulation signal does not exist, time is taken to effect a synchronizing operation immediately after the first station selecting information where the digital modulation signal exists. When the carrier reproduction is once established, the frequency division ratio data of the variable frequency divider 124 when the carrier reproducing operation of the digital demodulating circuit 122 is effected is fed onto the side of the microprocessor 108 from the microprocessor 128 so as to preserve the frequency division ratio data of the variable frequency divider 124 at the carrier reproduction time is normally being renewed on the side of the microprocessor 108. If the synchronization of the carrier reproducing circuit 22 is shifted, the frequency division ratio of the movable frequency divider 124 within the station selecting circuit 120 is first set in accordance with the newest frequency division data of the variable divider 124 which is preserved on the microprocessor 108 at the synchronizing time. The microprocessor 128 forces the frequency division ratio of the variable frequency divider 124 to vary around the set frequency division ratio so as to vary the oscillation frequency of the VCO 123 into a step shape. As the frequency of the digitally modulated IF signal is already retained constantly within a given range, the variable range when the frequency divider ratio of the variable frequency divider 124 is forced to vary is sufficient if it is enough to make up for the frequency variation of the stabilized IF signal already stabilized. Both the synchronizing leading-in time and the station selecting time are shortened.

Fig. 7 is a view showing the variation of the central frequency of the IF signal where the C/N ratio of the FM modulation signal has been changed with the central frequency of the FM modulation signal to be inputted to the frequency converting circuit 101 when the C/N ratio data by the C/N detecting circuit 53 is not taken into consideration in the embodiments of Fig. 5 and Fig. 6. There is no problem when the C/N ratio of the FM modulation signal is high as shown in Fig. 7, because the frequency of the IF signal conforms to the frequency corresponding to the reference value data. As the C/N ratio becomes lower, the frequency of the frequency dividing output signal of the frequency divider 51 becomes higher because of noises, and the error between the calculation value data calculated by the IF counter 52 and the reference value data is enlarged. The error becomes larger as the C/N ratio becomes lower. When the setting of the reference value data by the C/N ratio data is not changed, it is understood that the frequency of the FM modulated IF signal is shifted from the optimum input frequency of the FM demodulating circuit 102. In the embodiments of Fig. 5 and Fig. 6, set constant the reference value data to be compared with the calculation value data counted by the 1 F counter 52 in a level where the C/N ratio is a certain level or more and set the data higher as the C/N ratio is made lower in a level where the C/N ratio is a certain level or lower.

In the embodiments of Fig. 5 and Fig. 6, the C/N detecting circuit 53 is provided on the output side of the FM demodulating circuit 102 and the C/N ratio from the FM demodulating signal is detected. The circuit is not always required to be provided on the output side of the FM demodulating circuit 102. It may be provided on the input side or on the output side of the frequency converting circuit 101. If a method is a method capable of effecting the C/N ratio detecting operation, the detecting means of the C/N ratio is not restricted, needles to say, to the particular method.

In the embodiments of Fig. 1, Fig. 2, Fig. 3, Fig. 4, Fig. 5 and Fig. 6, such FM modulation signal as to establish the average value AFC is inputted in contents as the description of the frequency detecting circuit 110 of the AFC circuit 109. In the station selecting apparatus of the present invention, such a FM modulation signal as the keyed AFC signal is outputted is inputted. An output of an AFC circuit 109 may be, needless to say, such a FM modulation signal like a key data AFC signal.

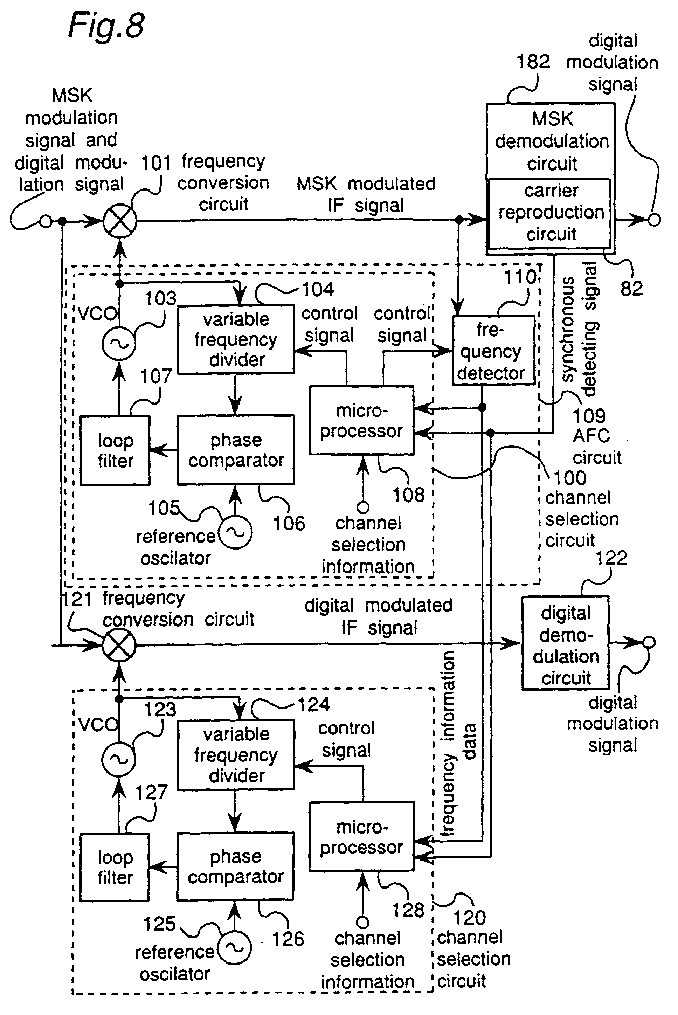

Fig. 8 is a station selecting apparatus in a still further embodiment of a present invention. The same reference numerals are given to the same locations as in the embodiment of Fig. 1. A frequency converting circuit 101 frequency-converts a MSK modulation signals into IF signals. The IF signals are fed to the MSK demodulating circuit 182 and is demodulated so as to output the digital demodulation signal. The MSK demodulating circuit 182 includes the carrier reproducing circuit 82 for reproducing the carrier.

A station selecting circuit 100 includes a VCO 103, a variable frequency divider 104, a reference oscillator 105, a phase comparator 106, a loop filter 107, a microprocessor 108. As the VCO 103 varies an oscillator frequency by a control signal to be given from a microprocessor 108, an oscillation frequency changes large by station selecting information to be inputted to the microprocessor 108 and the local oscillation signal of the VCO 103 is inputted into the frequency converting circuit 101 and a movable frequency divider 104. The variable frequency divider 104 divides the frequency with a frequency division ratio set by the microprocessor 108. The frequency division output of the variable frequency divider 104 is given to a phase comparator 106. The phase comparator 106 compares in phase a local oscillation signal to be divided in frequency by a variable frequency divider 104 with a reference frequency of the reference oscillator 105 so as to output a phase error signal. The phase error signal is smoothed with a loop filter 107 and is given as a control voltage for controlling the oscillation frequency of the VCO 103.

An AFC circuit 109 is provided for stabilizing the central frequency of an IF signal to be outputted from the frequency converting circuit 101 and includes a frequency detecting circuit 110 and a station selecting circuit 100. A frequency detecting circuit 110 detects the frequency of an IF signal FM-modulated, controls the frequency division ratio of the variable frequency divider 104 to be included in the station selecting circuit 100 in accordance with the frequency information data obtained by the frequency detecting circuit 110, finely adjusts the oscillation frequency of the VCO 103 and retains constant the frequency of the MSK modulated IF signal within the given range.

A frequency converting circuit 121 converts in frequency the digital modulation signal into an IF signal. The IF signal is fed to the digital demodulation circuit 122 and is demodulated.

A station selecting circuit 120 includes a VCO 123, a variable frequency divider 124, a reference oscillator 125, a phase comparator 126, a loop filter 127, a microprocessor 128. As a VCO 123 varies an oscillation frequency by a control signal to be given from the microprocessor 128, the oscillation frequency is changed large by station selecting information to be inputted to the microprocessor 128 and the local oscillation signal of the VCO 123 is inputted into the frequency converting circuit 121 and a variable frequency dividing 124. A variable frequency divider 124 divides the local oscillation signal with a frequency division ratio set by a microprocessor 128. The frequency dividing output of the variable frequency divider 124 is given to a phase comparator 126. The phase comparator 126 compares in phase the local oscillation signal divided in frequency by a variable frequency divider 124 with the reference frequency of the reference oscillator 125 so as to output the phase error signal. The phase error signal is smoothed and is given as a control voltage for controlling the oscillation frequency of the VCO 123.

The frequency information obtained by the frequency detecting circuit 110 is fed at the same time even to the microprocessor 128 so as to control the frequency dividing ratio of the variable frequency divider 124 to be included in the station selecting circuit 120 in accordance with the frequency information data, and the oscillation frequency of the VCO 123 is finely adjusted so as to maintain constant within the given range the frequency of the digitally modulated IF signal.

The operation of the station selecting apparatus in the embodiment of Fig. 1 will be described hereinafter. When the station selecting information where a MSK modulation signal exists is inputted to a microprocessor 108, the frequency dividing ratio corresponding to the station selecting information is set in the variable frequency divider 104 by the microprocessor 108. The VCO 103 feeds to the frequency converting circuit 101 the local oscillating signal corresponding to the station selecting information. The frequency converting circuit 101 converts the MSK modulation signal into an IF signal.

The frequency detecting circuit 110 is controlled by a microprocessor 108 so as to detect the frequency of the MSK modulated IF signal. The frequency information data is fed to the microprocessor 108. The microprocessor 108 calculates in accordance with the frequency information data the frequency error portion between the frequency of the MSK modulated IF signal and the optimum input frequency of the IF signal to be inputted to the MSK demodulating circuit 102 so as to finely adjust the frequency division ratio of the variable frequency divider 104 with respect to the frequency error portion. The frequency of the MSK modulated IF signal is stabilized so that it may stay within the given range around the optimum input frequency of the MSK demodulating circuit 102.

At the same time, the microprocessor 108 compulsorily varies the frequency dividing ratio of the variable frequency divider 104 around the frequency dividing ratio of the variable frequency divider 104 set in accordance with the frequency information data obtained by the station selecting information and the frequency detecting circuit 110 so as to change the oscillation frequency of the VCO 102 in a step shape. When the frequency of the IF signal approaches the frequency of the carrier reproducing circuit 82 so as to effect the carrier reproducing operation by the carrier reproducing circuit 82, the synchronizing detection signal is inputted into the microprocessor 108 from the MSK demodulating circuit 182 so as to suspend the variation of the frequency dividing ratio of the variable frequency divider 104.

When the station selecting information where the digital modulation signal exists is inputted to the microprocessor 128, the frequency dividing ratio corresponding to the station selecting station is set to the frequency converting circuit 121 by the microprocessor 128, and the VCO 123 feeds to the frequency converting circuit 121 the local oscillation signal corresponding to the station selecting information. The frequency converting circuit 121 converts the digital modulation signal into the IF signal.

When the synchronizing detection signal is outputted from the MSK demodulating circuit 182, the frequency information data of the MSK modulation signal obtained by the frequency detecting circuit 110 is fed even to the microprocessor 128. The microprocessor 128 calculates the frequency error portion between the frequency of the digitally modulated IF signal and the optimum input frequency of the digital demodulating circuit 122 in accordance with the frequency information, finely adjusts the frequency dividing ratio of the variable frequency divider 124 correspond in accordance with the frequency error portion, so that the frequency of the IF signal to be inputted to the digital demodulating circuit 122 is stabilized so that it may stay within the constant range around the optimum input frequency.

The embodiment of the present invention in Fig. 8 is a method of normally operating the AFC circuit 109 with respect to the MSK modulation signal the AFC circuit can easily generate, controlling the oscillation frequency of the VCO 123 by the frequency information data to be obtained by the AFC circuit 109, and reducing the shift from the optimum input frequency of the digital demodulation circuit 122 of the frequency of the IF signal. The frequency of the IF signal to be inputted to the digital demodulating circuit 122 can be easily stabilized so that it may stay within a constant range around the optimum input frequency. As the frequency of the IF signal stays within relatively narrow constant range around the synchronizing leading-in frequency of the digital demodulation circuit 122 so that both the synchronizing leading-in time of the digital demodulating circuit 122 and the station selecting time can be also shortened.

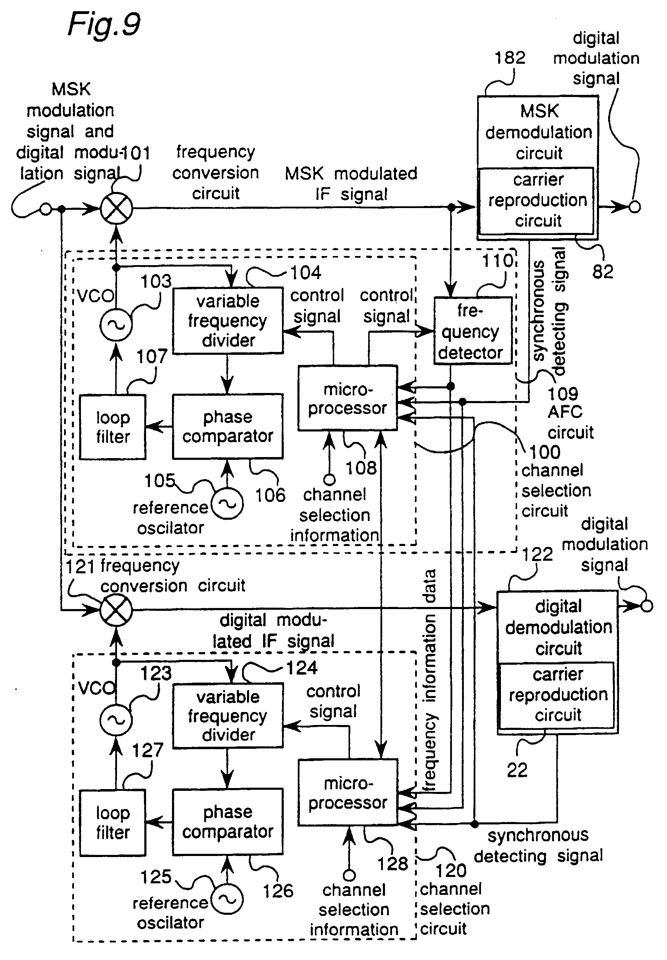

Fig. 9 is a station selecting apparatus in another important embodiment by he present invention with the same reference numerals being given to the same locations in Fig. 8 for description. The frequency converting circuit 101 converts in frequency the MSK modulation signal into the IF signal. The IF signal is fed to the MSK demodulating circuit 182, is demodulated and the digital demodulation signal is outputted. The MSK demodulating circuit 182 includes the carrier reproducing circuit 82 for reproducing the carrier. The digital demodulating circuit 122 includes the carrier reproducing circuit 22 for reproducing the carrier. The carrier reproducing operation is effected by the carrier reproducing circuit 22 and the synchronizing detection signal is fed to the microprocessors 108, 128 from the digital demodulating circuit 122. In the embodiment of Fig. 8, the oscillation frequencies of the VCOs 103, 123 are controlled in accordance with the frequency information data obtained by the frequency detecting circuit 110 and the synchronizing detection signal only obtained by the MSK demodulating circuit 182. The embodiment of Fig. 9 is different in that the oscillation frequencies of the VCOs 103, 123 are controlled by the synchronizing detection signal obtained by the digital demodulating circuit 122 in addition to the frequency information data and the synchronizing detection signal to be obtained by the MSK demodulating circuit 182.

The operation of the station selecting apparatus by the embodiment of Fig. 5 will be described hereinafter. When the station selecting information where MSK modulation signal exists is inputted to the microprocessor 108, the frequency division ratio corresponding to the station selecting information is set in the variable frequency divider 104 by the microprocessor 108 and the VCO 103 feeds the local oscillation signal corresponding to the station selecting information to the frequency converting circuit 101. The frequency converting circuit 101 converts the MSK modulation signal into the IF signal.

The frequency detecting circuit 110 is controlled by the microprocessor 108, detects the frequency of the MSK modulated IF signal, and the frequency information data is fed to the microprocessor 108. The microprocessor 108 calculates the frequency error portion between the frequency of the MSK modulated IF signal and the optimum input frequency of the IF signal to be inputted to the MSK demodulating circuit 182 in accordance with the frequency information data so as to finely adjust the frequency dividing ratio of the variable frequency divider 104 in accordance with the frequency error portion and the frequency of the NSK modulated IF signal is stabilized to stay within a constant range around the optimum input frequency of the MSK demodulating circuit 182.

When the IF signal to be inputted to the digital demodulating circuit 122 stays within the constant range around the optimum input frequency, the microprocessor 108 forces the frequency dividing ratio of the variable frequency divider 104 variable around the frequency division ratio of the variable frequency divider 104 set in accordance with the station selecting information and the frequency information data obtained by the frequency detecting circuit 110 so as to change the oscillation frequency of the VCO 123 into a step shape. When the frequency of IF signal approaches the frequency of the carrier reproducing circuit 82 to effect the carrier reproducing operation, the synchronizing detection signal is inputted into the microprocessor 108 from the MSK demodulating circuit 182 so as to suspend the variation of the frequency dividing ratio of the variable frequency divider 104.

When the station selection information where the digital modulation signal exists is inputted to a microprocessor 128, the frequency dividing ratio in accordance with the station selecting information obtained by the station selecting information and the frequency detecting circuit 110 by the microprocessor 128 is set in the variable frequency divider 124. The VCO 123 feeds to the frequency converting circuit 101 the local oscillating signal corresponding to the station selecting information. The frequency converting circuit 121 converts the digital converting signal into an IF signal.

When the synchronizing detection signal from the MSK demodulating circuit 182 is outputted, the frequency information data of the MSK modulation signal obtained by the frequency detecting circuit 110 is fed even to the microprocessor 128. The microprocessor 128 calculates in accordance with the frequency information data the frequency error portion between the frequency of the digitally modulated IF signal and the optimum input frequency of the IF signal to be inputted to the digital demodulating circuit 122 so as to finely the frequency division ratio of the variable frequency divider 124 with respect to the frequency error portion and the frequency of the IF signal to be inputted to the digital demodulating circuit 122 is stabilized so that it may stay within the given range around the optimum input frequency.

The frequency of the IF signal to be inputted to the digital demodulating circuit 122 stays within a constant range around the optimum input frequency and at the same time, the microprocessor 128 compulsorily varies the frequency dividing ratio of the variable frequency divider 124 around the set frequency dividing ratio so as to vary the oscillation frequency of the VCO 123 into a step shape. When the frequency of the IF signal approaches the frequency of the carrier reproducing circuit 22 to effect the carrier reproducing operation, the synchronizing detection signal is inputted to the microprocessor 128 from the digital demodulating circuit 122 so that the variation of the frequency dividing ratio of the variable frequency divider 124 is suspended.

When the MSK modulation signal does not exist, the first station selecting information where the digital modulation signal exists is inputted to the microprocessor 128 so as to, first, set the frequency dividing ratio corresponding to the station selecting information to the variable frequency divider 124 by the microprocessor 128, and the VCO 123 feeds to the frequency converting circuit 121 the local oscillation signal corresponding to the station selecting information. The frequency converting circuit 121 converts into the IF signal the digital modulating signal. The microprocessor 128 forces the frequency division ratio of the variable frequency divider 124 to be varied around the frequency division ratio to be set in accordance to the first station selecting information for varying the oscillation frequency of the VCO 123 into a step shape. The variable range of the frequency division ratio of the variable frequency divider 124 is set so that the frequency of the digital modulation signal may make up for the frequency variation the frequency of the digital modulation signal receives on an intermediate propagation path. When the frequency of the IF signal approaches the frequency of the carrier reproducing circuit 22 so as to effect the carrier reproducing operation, the synchronizing detection signal is inputted to the microprocessor 128 from the digital demodulating circuit 122 for suspending the variation of the frequency division ratio of the variable frequency divider 124.

On the side of the microprocessor 108 side, the frequency division data of the variable frequency divider 124 is received from the side of the microprocessor 128 while the synchronizing detection signal is outputted from the digital demodulating circuit 122. On the side of the microprocessor 108, the frequency division ratio of the variable frequency divider 124 at the carrier reproducing time, instead of the frequency information data to be obtained by the frequency detecting circuit 110, is preserved while being normally renewed. When the synchronization of the carrier reproducing circuit 22 is disconnected, the frequency division ratio of the variable frequency divider 124 within the station selecting circuit 120 is, first, set in accordance with the newest frequency division ratio of the variable frequency divider 124 which is preserved on the microprocessor 108. The microprocessor 128 forces the frequency division ratio of the variable frequency divider 124 to vary around the set frequency division ratio so as to vary the oscillation frequency of the VCO 123 into a step shape. As the frequency of the digitally modulated IF signal is already retained constant within a given range and the variable range of the frequency division ratio of the variable frequency divider 124 is sufficient if it is enough to make up for the frequency variation of the stabilized IF signal. When the frequency of the IF signal approaches the frequency of the carrier reproducing circuit 22 so as to effect the carrier reproduction again, the synchronizing detection signal is inputted to the microprocessor 128 from the digital demodulating circuit 122 for suspending the variation of the frequency division ratio of the variable frequency divider 124.

The embodiment of the present invention in Fig. 9 is a method of normally operating the AFC circuit 109 with respect to the SKM modulation signal the frequency can easily detect when the MSK modulation signal exits, controlling the frequency shift of the station selecting circuit 120 for the digital modulating signal use by the frequency information data to be obtained by the AFC circuit 109, and reducing the shift from the optimum input frequency of the digital demodulation circuit 122 of the frequency of the IF signal. The IF signal to be inputted to the digital demodulating circuit 122 can be easily stabilized so that it may stay within a constant range around the optimum input frequency. As the frequency of the IF signal stays within relatively narrow constant range around the synchronizing leading-in frequency of the digital demodulation circuit 122 so that both the synchronizing leading-in time of the digital demodulating circuit 122 and the station selecting time can be also shortened.

When the MSK modulation signal does not exist, time is taken to effect a synchronizing operation immediately after the first station selecting information where the digital modulation signal has been inputted. When the carrier reproduction is once established, the frequency division ratio of the variable frequency divider 124 when the carrier reproducing operation of the digital demodulating circuit 122 is effected is fed onto the side of the microprocessor 108 from the microprocessor 128 so as to preserve the frequency division ratio data of the variable frequency divider 124 at the carrier reproduction time while normally being renewed on the side of the microprocessor 108. If the synchronization of the carrier reproducing circuit 22 is shifted, the frequency division ratio of the movable frequency divider 124 within the station selecting circuit 120 is first set in accordance with the newest frequency division data of the variable divider 124 which is preserved on the microprocessor 108 at the synchronizing time. The microprocessor 128 forces the frequency division ratio of the variable frequency divider 124 around the set frequency division ratio so as to vary the oscillation frequency of the VCO 123 into a step shape. As the frequency of the digitally modulated IF signal is already retained constantly within a given range, the variable range when the frequency dividing ratio of the variable frequency divider 124 is forced to be variable is sufficient if it is enough to make up for the frequency variation amount of the frequency of the IF signal already stabilized. Both the synchronizing leading-in time and the station selecting time are shortened.

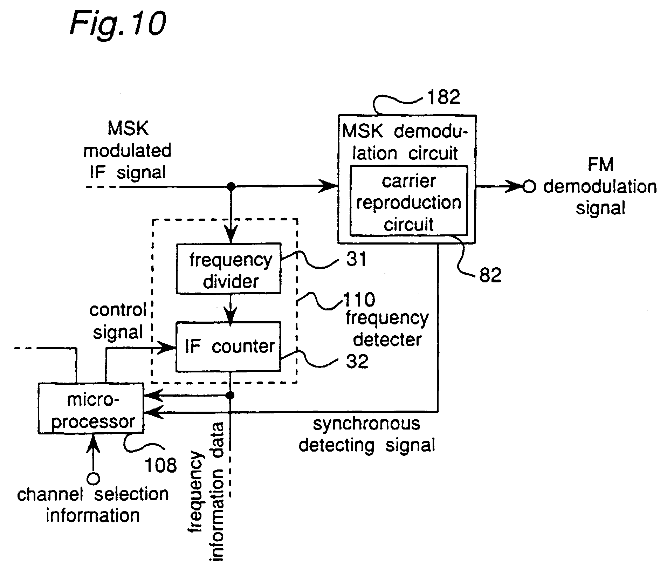

Fig. 10 is a view showing one example of a frequency detecting circuit 110 shown in Fig. 8 and Fig. 9. The same reference numerals are given to the same locations as in Fig. 3 for description thereof. The frequency detecting circuit 110 includes a frequency divider 31 and an IF counter 32 in Fig. 10. The frequency divider 31 divides the MSK modulated IF signal. The IF counter 32 counts the frequency of the IF signal divided by the frequency divider 31. The microprocessor 108 controls the IF counter 32 so that the frequency dividing signal frequency of the IF signal divided by the frequency divider 31 may be counted for a constant period by the IF counter 32 so as to receive a calculated value counted by an IF counter 32. The microprocessor 108 compares a received calculation value data with a reference value set previously within the microprocessor 108. In accordance with the comparison results, the frequency error portion between the frequency of the MSK modulated IF signal and the optimum input frequency of the MSK demodulating circuit 102 is calculated. The frequency dividing ratio of the variable frequency divider 104 is finely adjusted in accordance with the frequency error portion and the frequency of the MSK modulated IF signal is stabilized so that it may stay within a constant range around the optimum input frequency.

When the carrier reproducing operation is effected by the MSK demodulating circuit 182, the calculation value data counted by the IF counter 32 is received at the same time even to the microprocessor 128, and is compared with a reference value data predetermined with the microprocessor 128. In accordance with the comparison results, the frequency error portion between the frequency of the digitally modulated IF signal and the optimum input frequency of the IF signal to be inputted to the digital demodulating circuit 122 is calculated. The frequency dividing ratio of the variable frequency divider 124 is finely adjusted in accordance with the frequency error portion and the frequency of the IF signal to be inputted to the digital demodulating circuit 122 is stabilized so that it may stay within a constant range around the optimum input frequency.

In the embodiments of the Fig. 8, Fig. 9 and Fig. 10, the description is given where the MSK modulation signal in which the average value AFC is established as an AFC circuit 109 is inputted. In the station selecting apparatus of the present invention, the phase sequence digital modulation signal where the average value AFC is established will do, needless to say, if it is not a MSK modulation signal.

In the embodiment from Fig. 1 through Fig. 10, no description is given about the relation between the reference frequency of the reference oscillator 105 and the reference frequency of the reference oscillator 125. Both the reference frequency may be the same frequency, and may be different. The reference oscillator 105 may be the same as the reference oscillator 125.

Although the microprocessor 108 and the microprocessor 128 have been described as different one in the above described description, both the microprocessors may be composed of one microprocessor.

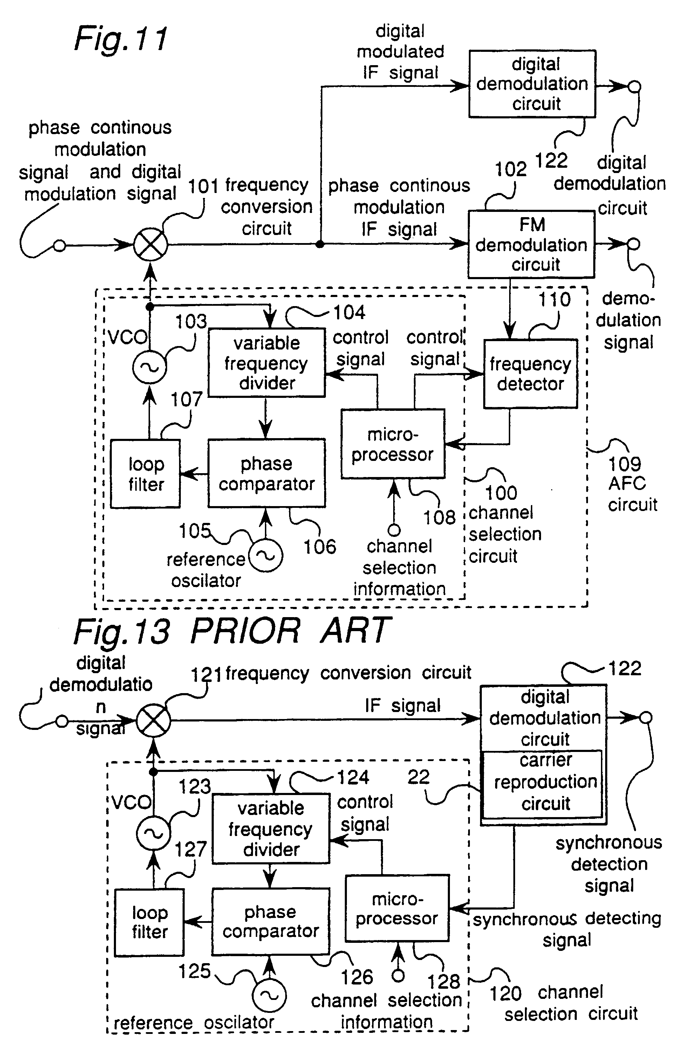

Fig. 11 is a station selecting apparatus in a different embodiment of the present invention. The same reference numerals are given to the same locations as in Fig. 1 for description thereof. A frequency converting circuit 101 frequency-converts a phase sequence modulation signal or the digital modulation signal into an IF signal. The IF signals are fed to a demodulating circuit 102 or a digital demodulating circuit 122 and are demodulated. A station selecting circuit 100 includes a VCO 103, a variable frequency divider 104, a reference oscillator 105, a phase comparator 106, a loop filter 107, a microprocessor 108. As the VCO 103 varies an oscillator frequency by a control signal to be given from a microprocessor 108, an oscillation frequency changes large by the station selecting information to be inputted to the microprocessor 108 and the local oscillation signal of the VCO 103 is inputted into the frequency converting circuit 101 and a movable frequency divider 104. The variable frequency divider 104 divides the frequency with a frequency division ratio set by the microprocessor 108. The frequency division output of the variable frequency divider 104 is given to a phase comparator 106. The phase comparator 106 compares in phase a local oscillation signal to be divided in frequency by a variable frequency divider 104 and a reference frequency of the standard oscillator 105 so as to output a phase error signal. The phase error signal is smoothed with a loop filter 107 and is given as a control voltage for controlling the oscillation frequency of the VCO 103.

An AFC circuit 109 is provided for stabilizing the central frequency of an IF signal to be outputted from the frequency converting circuit 101 and includes a frequency detecting circuit 110 and a station selecting circuit 100. A frequency detecting circuit 110 detects the frequency of an IF signal modulated in phase sequence, controls the frequency division ratio of the variable frequency divider 104 in accordance with the frequency information data obtained by the frequency detecting circuit 110, finely adjusts the oscillation frequency of the VCO 103 and retains the frequency of the IF signal modulated in phase sequence.

The operation of the station selecting apparatus in the embodiment of Fig. 11 will be described hereinafter. When the station selection information where a phase sequence modulation signal exists is inputted to a microprocessor 108, the frequency dividing ratio corresponding to the station selecting information is set in the variable frequency divider 104. The VCO 103 feeds to the frequency converting circuit 101 the local oscillating signal corresponding to the station selecting information. The frequency converting circuit 101 converts the phase sequence modulating signal into an IF signal.

The frequency detecting circuit 110 is controlled by a microprocessor 108 so as to detect the frequency of the IF signal modulated in phase sequence modulation signal. The frequency information data is fed to the microprocessor 108. The microprocessor 108 calculates in accordance with the frequency information data the frequency error portion between the frequency of the IF signal modulated in phase sequence and the optimum input frequency of the IF signal to be inputted to the demodulating circuit 102 so as to finely adjust the frequency division ratio of the variable frequency divider 104 with respect to the frequency error portion to stabilize so that the frequency of the IF signal may stay within the given range around the optimum input frequency of the demodulating circuit 102. At this time, the error information about the frequency error portion between the frequency of the IF signal modulated in phase sequence and the optimum input frequency of the IF signal to be inputted to the demodulating circuit 102, together with the station selection information, is stored and preserved within the microprocessor 108.

When the station selecting information where the digital modulating signal exists is inputted to the microprocessor 128, the frequency dividing ratio corresponding to the station selecting information is set to the variable frequency divider 104 so that the VCO 123 feeds the local oscillation signal corresponding to the station selecting information to the frequency converting circuit 121. The frequency converting circuit 101 converts the digital modulating signal into an IF signal.

In accordance with the error information and the station selecting information stored and preserved within the microprocessor 102, the frequency error difference between the frequency of the digitally modulated IF signal and the optimum input frequency of the digital demodulating circuit 122 is calculated and the frequency difference ratio of the movable frequency divider 104 is finely adjusted in accordance with the frequency error portion, and the frequency of the IF signal to be inputted to the digital demodulating circuit 122 is stabilized so that it may stay within a given range around the optimum input frequency.

The frequency of the IF signal to be inputted to the digital demodulation circuit 122 can be stabilized so that it may stay within a constant range around the optimum input frequency in accordance with the frequency information data of the phase sequence signal to be obtained by the frequency detecting circuit 110, because both the phase sequence modulations signal and the digital modulation signal are received in the common frequency variation of the same or the almost the same inclination by an intermediate propagation path in the satellite broadcasting operation, and the frequency variation amount the frequency of the phase sequence modulating signal receives by the intermediate propagation path is equal to or almost equal to the frequency variation amount the frequency of the digital modulation signal receives by the intermediate propagation path, and the frequency difference between the phase sequence modulation signal and the digital modulation signal is equal to the frequency difference between the nominal channels. In the ground broadcasting, the transmission frequencies of the phase sequence modulation signal and the digital modulation signal are very stable in the given frequency. The frequency variation the frequency of the IF signal modulated in the phase sequence is mainly the frequency variation by the shift from the set frequency of the standard frequency of the standard oscillator 105, the shift from the given frequency of the local oscillator in the frequency converting circuit not shown except for the frequency converting circuit 101. The frequency variation amount is hardly determined by the frequency ratio of the variable frequency divider 104 corresponding to the station selecting information. Assume that the percentage of the shift from the set frequency F0 of the reference frequency F1 of the reference oscillator 105 modulated in phase sequence is F1/F0, and the frequency of VCO 103 is FV, and the frequency variation amount the IF signal receives by the frequency converting circuit 101 becomes FV * F1/F0, so that the percentage of the shift from the set frequency F0 of the reference frequency F1 of the reference oscillator 105 as it is determines the size of the frequency variation amount.

The embodiment of the present invention in Fig. 11 is a method of normally operating the AFC circuit 109 with respect to the phase sequence modulation signal the AFC circuit 109 can easily generate, calculating the frequency error portion between the frequency of the IF signal and the optimum input frequency of the IF signal with the frequency information data to be obtained by the AFC circuit 109, finely adjusting the frequency dividing ratio of the movable frequency divider 104 in accordance with the frequency error portion, controlling the oscillation frequency of the VCO 103. It is a method of reducing the shift from the optimum input frequency of the digitally demodulated IF signal by the error information about the frequency error portion. The frequency of the IF signal to be inputted to the digital demodulating circuit 122 can be easily stabilized so that it may stay within a constant range around the optimum input frequency. As the frequency of the IF signal stays within relatively narrow constant range around the synchronizing leading-in frequency of the digital demodulation circuit 122 so that both the synchronizing leading-in time of the digital demodulating circuit 122 can be also shortened.

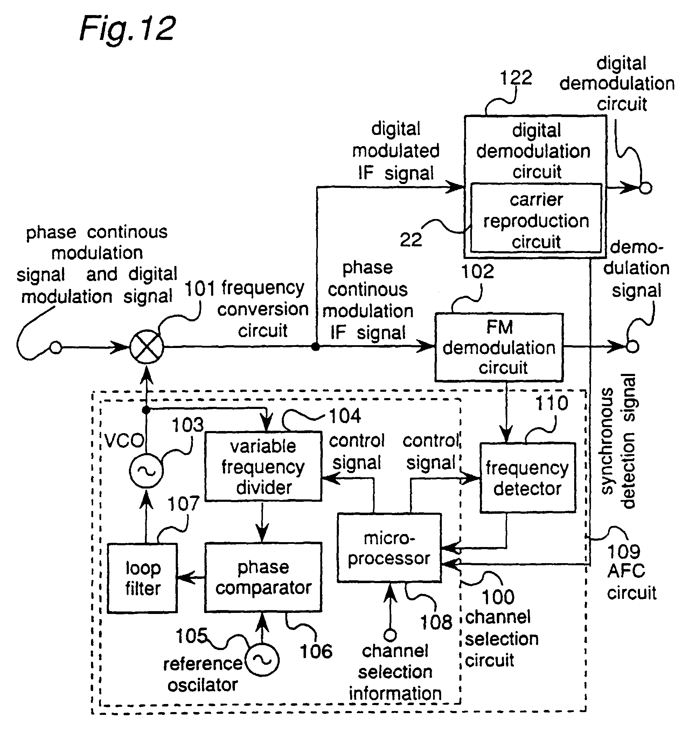

Fig. 12 is a station selecting apparatus of a different embodiment by the present invention with the same reference numerals being given to the same locations in Fig. 11 for description thereof. The digital demodulating circuit 122 includes the carrier reproducing circuit 22 for reproducing the carriers. The carrier reproducing operation is effected by the carrier reproducing circuit 22 and the synchronizing detection signal is fed to the microprocessor 102 from the digital demodulating circuit 122. In the embodiment of Fig. 11, the oscillation frequency of the VCO 103 is controlled in accordance with only the frequency information data obtained by the frequency detecting circuit 110. Fig. 12 is different in embodiment from Fig. 11 in that the oscillation frequency of the VCO 103 is controlled by the synchronizing detection signal obtained by the digital demodulating circuit 122 except for the frequency information data.

The operation of the station selecting apparatus by the embodiment of Fig. 12 will be described hereinafter. When the station selecting information where the phase sequence modulation signal exists is inputted to the microprocessor 108, the frequency division ratio corresponding to the station selecting information is set in the variable frequency divider 104 and the VCO 103 feeds the local oscillation signal corresponding to the station selecting information to the frequency converting circuit 101. The frequency converting circuit 101 converts the phase sequence modulation signal to the IF signal.

The frequency detecting circuit 110 is controlled by the microprocessor 108, detects the frequency of the phase sequence modulated IF signal, and the frequency information data is fed to the microprocessor 108. The microprocessor 108 calculates the frequency error portion between the frequency of the phase sequence modulated IF signal and the optimum input frequency of the IF signal to be inputted to the demodulating circuit 102 in accordance with the frequency information data so as to finely adjust the frequency dividing ratio of the variable frequency divider 104 in accordance with the frequency error portion and the frequency of the IF signal modulated in phase sequence is stabilized to stay within a constant range around the optimum input frequency of the demodulating circuit 102. At this time, the error information between the frequency of the IF signal modulated in phase sequence and the optimum input frequency to be inputted to the demodulating circuit 102, together with the station selection information, is stored and preserved within the microprocessor 108.

When the station selecting information where the digital modulating signal exists is inputted to the microprocessor 108, the frequency dividing ratio corresponding to the station selecting information is set to the variable frequency divider 104 so that the VCO 103 feeds the local oscillation signal corresponding to the station selecting information to the frequency converting circuit 101. The frequency converting circuit 101 converts the digital modulating signal into an IF signal. In accordance with the error information and the station selecting information stored and preserved within the microprocessor 103, the frequency error difference between the frequency of the digitally modulated IF signal and the optimum input frequency of the digital demodulating circuit 122 is calculated and the frequency difference ratio of the movable frequency divider 104 is finely adjusted in accordance with the frequency error portion, and the frequency of the IF signal to be inputted to the digital demodulating circuit 122 is stabilized so that it may stay within a given range around the optimum input frequency.

The frequency of the IF signal to be inputted to the digital demodulating circuit 122 stays within a constant range around the optimum input frequency and the synchronizing detection signal is not outputted, the microprocessor 108 compulsorily varies the frequency dividing ratio of the variable frequency divider 104 around the frequency dividing ratio set after the fine adjustment so as to vary the oscillation frequency of the VCO 103 into a step shape. When the frequency of the IF signal approaches the frequency of the carrier reproducing circuit 22 to effect the carrier reproducing operation, the synchronizing detection signal is inputted to the microprocessor 108 from the digital demodulating circuit 122 so that the variation of the frequency dividing ratio of the variable frequency divider 124 is suspended.

In the microprocessor 102, the frequency dividing ratio data of the variable frequency divider 104, instead of the frequency information data to be obtained by the frequency detecting circuit 110, is preserved, being normally being renewed while the synchronizing detection signal from the digital demodulating circuit 122 is being outputted. When the synchronization of the carrier reproducing circuit 22 is disengaged by the inputting operation of the different station selecting information, or the like, the frequency dividing ratio of the variable divider 104 is, first, set in accordance with the newest frequency dividing ratio data of the variable frequency divider 104 to be preserved within the microprocessor 103. When the frequency of the IF signal to be inputted into he digital demodulating circuit 122 stays within the constant range around the optimum input frequency, and the synchronizing detection signal is not outputted, the microprocessor 103 compulsorily varies the frequency dividing ratio of the variable frequency divider 104 around the set frequency dividing ratio so as to vary the oscillation frequency of the VCO 103 like a step shape. As the frequency of the digitally modulated IF signal is already retained constantly within a given range, the variable range of the frequency dividing ratio of the variable frequency divider 104 is sufficient if it is enough to make up for the frequency variation of the stabilized IF signal. The frequency of the IF signal approaches the frequency of the carrier reproducing circuit 22 so as to effect the carrier reproducing operation again, the synchronizing detection signal is inputted into the microprocessor 108 from the digital demodulating circuit 122 for suspending the variation of the frequency dividing ratio of the variable frequency divider. A series of operations of obtaining such synchronism is repeated each time the synchronism is disengaged.

When the phase sequence modulation signal does not exist, the first station selecting information where the digital modulation signal exists is inputted to the microprocessor 108 so as to, first, set the frequency dividing ratio corresponding to the selecting station information to the variable frequency divider 104, and the VCO 103 feeds to the frequency converting circuit 121 the local oscillation signal corresponding to the station selecting information. The frequency converting circuit 121 converts into the IF signal the digital modulating signal. The microprocessor 108 forces the frequency division ratio of the variable frequency divider 104 to be varied around the frequency division ratio to be set in accordance with the first station selecting information for varying the oscillation frequency of the VCO 103 into a step shape. The variable range of the frequency division ratio of the variable frequency divider 104 is set so that the frequency of the digital modulation signal may make up for sufficiently the frequency modulation amount the frequency of the digital modulation signal receives on an intermediate propagation path. When the frequency of the IF signal approaches the frequency of the carrier reproducing circuit 22 so as to effect the carrier reproducing operation, the synchronizing detection signal is inputted to the microprocessor 108 from the digital demodulating circuit 122 for suspending the variation of the frequency division ratio of the variable frequency divider 104.

In the microprocessor 102, the frequency dividing ratio data of the variable frequency divider 104, instead of the frequency information data to be obtained by the frequency detecting circuit 110, is preserved, being normally renewed while the synchronizing detection signal from the digital demodulating circuit 122. When the carrier reproducing circuit 22 is disengaged from the synchronism by the inputting operation of the different station selecting information or the like, the frequency dividing ratio of the variable divider 104 is, first, set in accordance with the newest frequency dividing ratio data of the variable frequency divider 104 to be preserved within the microprocessor 102. When the frequency of the IF signal to be inputted into the digital demodulating circuit 122 stays within the constant range around the optimum input frequency, and the synchronizing detection signal is not outputted, the microprocessor 103 compulsorily varies the frequency dividing ratio of the variable frequency divider 104 around the set frequency dividing ratio so as to vary the oscillation frequency of the VCO 103 like a step shape. As the frequency of the digitally modulated IF signal is retained constantly within a given range and is stabilized, the variable range of the frequency dividing ratio of the variable frequency divider 104 is sufficient enough to make up for the frequency variation of the stabilized IF signal. The frequency of the IF signal approaches the frequency of the carrier reproducing circuit 22 so as to effect the carrier reproducing operation again, the synchronizing detection signal is inputted into the microprocessor 108 from the digital demodulating circuit 122 for suspending the variation of the frequency dividing ratio of the variable frequency divider. A series of operations of obtaining such synchronism is repeated each time the synchronism is disengaged.

The embodiment of the present invention in Fig. 12 is a method of operating the AFC circuit 109 with respect to the phase sequence modulation signal the frequency can easily detect when the FM modulation signal exits, calculating the frequency error portion between the frequency of the IF signal and the optimum input frequency of the IF signal by the frequency information data to be obtained by the AFC circuit 109, finely adjusting the frequency dividing ratio of the variable frequency divider 104 in accordance with the frequency error portion, controlling the oscillation frequency of the VCO 103. It is a method of reducing the shift from the optimum input frequency of the digitally demodulated IF signal by the error information about the frequency error portion. The IF signal to be inputted to the digital demodulating circuit 122 can be easily stabilized so that it may stay within a constant range around the optimum input frequency. As the frequency of the IF signal stays within relatively narrow constant range around the synchronizing leading-in frequency of the digital demodulating circuit 122 so that the synchronizing leading-in time of the digital demodulating circuit 122 is shortened.

When the FM modulation signal does not exist, time is taken to effect a synchronizing operation immediately after the first station selecting information where the digital modulation signal exists has been inputted. When the carrier reproduction is once established, the frequency division ratio data of the variable frequency divider 104 is preserved while being normally renewed while the synchronizing detection signal from the digital demodulating circuit 122 is outputted in the microprocessor 108. If the synchronization of the carrier reproducing circuit 22 is disengaged by the inputting operation of the different station selecting information, the frequency division ratio of the movable frequency divider 124 is first set in accordance with the newest frequency division ratio data of the variable divider 124 which is preserved within the microprocessor 108 at the synchronizing time. The microprocessor 108 forces the frequency division ratio of the variable frequency divider 124 around the set frequency division ratio to vary so as to vary the oscillation frequency of the VCO 123 into a step shape. As the frequency of the digitally modulated IF signal is already retained constantly within a given range, the variable range when the frequency divider ratio of the variable frequency divider 104 is forced to be varied is sufficient if it is enough to make up for the frequency variation of the frequency of the IF signal already stabilized. The synchronizing leading-in time is shortened.

In the embodiments of the above described Fig. 11 and Fig. 12, the IF signal which is the output signal of the frequency converting circuit 101 is adapted to be inputted directly to the demodulating circuit 102 and the digital demodulating circuit 122. A different frequency converting circuit may be provided between the frequency converting circuit 101 and the demodulating circuit 102, single demodulating circuits of the digital demodulating circuit 122 or a different frequency converting circuit may be interposed between a frequency converting circuit 101 and a demodulating circuit 102, both demodulating circuits of the digital demodulating circuit 122.

Although the present invention has been fully described by way of example with reference to the accompanying drawings, it is to be noted here that various changes and modifications will be apparent to those skilled in the art. Therefore, unless otherwise such changes and modifications depart from the scope of the present invention, they should be construed as included therein.

## Claims

1. A station selecting apparatus comprising a station selecting circuit for carrier phase sequence modulation signal use, which includes a first frequency converting circuit for frequency-converting modulation signals continued in a carrier phase so as to output a first intermediate frequency signal, a first station selecting means provided with a first voltage control oscillator for changing the oscillation frequency by station selecting information, and for feeding to the first frequency converting circuit the local oscillation signal of the first voltage controlling oscillator, a frequency information detecting means for detecting the frequency information of the first intermediate frequency signal, a first frequency controlling means for receiving frequency information obtained by the frequency information detecting means, finely adjusting the oscillation frequency of the first voltage control oscillator so that the frequency of the first intermediate frequency signal may stay within the given frequency range, and of a station selecting circuit for digital modulation signal use, which includes a second frequency converting circuit for frequency-converting the digitally modulated digital modulation signal so as to output the second intermediate frequency signal, a second station selecting means provided with a second voltage control oscillator for changing the oscillation frequency by station selecting information and for feeding to the second frequency converting circuit the local oscillation signal of the second voltage control oscillator; a second frequency controlling means for receiving frequency information obtained by the frequency information detecting means, finely adjusting the oscillation frequency of the second voltage controlling oscillator so that the frequency of the second intermediate frequency signal may stay in the given frequency range.

2. A station selecting apparatus as defined in claim 1, where a modulation signal continued in the carrier phase is a FM-modulated FM modulation signal.

3. A station selecting apparatus as defined in claim 2, where a frequency information detecting means for detecting the frequency information of the first intermediate frequency signal is a calculating means for counting the frequency of the first intermediate frequency signal, the first frequency controlling means compares a calculated value output data of the calculating means with a reference value data previously set so as to finely adjust the oscillation frequency of the first voltage controlling oscillator so that the comparison output data may stay within a given range.

4. A station selecting apparatus as defined in claim 2, where a frequency information detecting means for detecting the frequency information of the first intermediate frequency signal is a means for making the FM demodulating circuit of the first intermediate frequency signal a PLL demodulating circuit so as to detect the central frequency of the first intermediate signal from the direct current component of a FM demodulation signal which is an output signal of the FM demodulating circuit, the first frequency controlling means is a means for comparing a direct current component of the FM demodulation signal with the previously set reference voltage so as to finely adjust the oscillation frequency of the first voltage control oscillator so that the compared output values may stay within the given range.

5. A station selecting apparatus as defined in claim 2 further comprising a C/N detecting means for detecting the C/N ratio of a FM modulation signal, a frequency information detecting means for detecting the frequency information of the first intermediate frequency signal is a means for calculating the frequency of the first intermediate frequency signal, and wherein the first frequency controlling means is a means for setting in accordance with the C/N ratio data obtained by the C/N detecting means the reference value data to be compared with the calculated value output data of the calculating means so as to finely adjust the oscillation frequency of the first voltage control oscillator so that the comparison output data where the calculated output data of the calculating means is compared with the reference value data may stay within a given range.

6. A station selecting apparatus as defined in claim 2 further comprising a carrier reproducing circuit for reproducing the carrier of the second intermediate frequency signal so as to output the synchronizing detection signal of the carrier, the second frequency controlling means receives frequency information obtained by the frequency information detecting means, when the FM modulation signal is inputted into the first frequency converting circuit, to finely adjust the oscillation frequency of the second voltage controlling oscillator so that the frequency of the second intermediate frequency signal may stay in a given frequency range, and, when the FM modulation signal is not inputted to the first frequency converting circuit, to finely adjust the oscillation frequency of the second voltage controlling oscillator before the synchronizing detection signal is adapted to be outputted so that the frequency of the second intermediate frequency signal may stay within a given range.

7. A station selecting apparatus as defined in claim 6, where a frequency information detecting means for detecting the frequency information of the first intermediate frequency signal is a means for calculating the frequency of the first intermediately frequency signal, the first frequency controlling means is a means for comparing the calculated value output data of the digits with the previously set reference value data so as to finely adjust the oscillation frequency of the first voltage control oscillator so that the compared output data may stay within the given range.

8. A station selecting apparatus as defined in claim 6, where a frequency information detecting means for detecting the frequency information of the first intermediate frequency signal is a means for making the FM demodulating circuit of the first intermediate frequency signal a PLL demodulating circuit so as to detect the central frequency of the first intermediate signal from the direct current component of a FM demodulation signal which is an output signal of the FM demodulating circuit, the first frequency controlling means is a means for comparing a direct current component of the FM demodulation signal with the previously set reference voltage so as to finely adjust the oscillation frequency of the first voltage control oscillator so that the compared output value may stay within the given range.

9. A station selecting apparatus as defined in claim 6, further comprising a C/N detecting means for detecting the C/N ratio of a FM modulation signal, and wherein a frequency information detecting means for detecting the frequency information of the first intermediate frequency signal is a means for calculating the frequency of the first intermediate frequency signal, the first frequency controlling means is a means for setting in accordance with the C/N ratio data obtained by the C/N detecting means the reference value data to be compared with the calculated value output data of the calculating means so as to finely adjust the oscillation frequency of the first voltage controlling oscillator so that the comparison output data where the calculated output data of the calculating means is compared with the reference value data may stay within a given range.

10. A station selecting apparatus as defined in claim 1, where the modulation signal continued in a carrier phase is a phase continuous digital modulation signal.

11. A station selecting apparatus as defined in claim 10, where a frequency information detecting means for detecting the frequency information of the first intermediate frequency signal is a means for measuring the frequency of the first intermediate frequency signal, the first frequency controlling means is a means for comparing the calculated value output data of the counting means with the previously set reference value data so as to finely adjust the oscillation frequency of the first voltage control oscillator so that the compared output data may stay within the given range.

12. A station selecting apparatus as defined in claim 10, further comprising a carrier reproducing circuit for reproducing the carrier of the second intermediate frequency signal so as to output the synchronizing detection signal of the carrier, the second frequency controlling means receives frequency information obtained by the frequency information detecting means, when the phase continuous digital modulation signal is inputted to the first frequency converting circuit, to finely adjust the oscillation frequency of the second voltage controlling oscillator so that the frequency of the second intermediate frequency signal may stay in a given frequency range, and, when the phase continuous digital modulation signal is not inputted to the first frequency converting circuit, to finely adjust the oscillation frequency of the second voltage controlling oscillator before the synchronizing detection signal is adapted to be outputted so that the frequency of the second intermediate frequency signal may stay within a given range.

13. A station selecting apparatus as defined in claim 12, where a frequency information detecting means for detecting the frequency information of the first intermediate frequency signal is a means for measuring the frequency of the first intermediate signal, the first frequency controlling means is a frequency controlling means for comparing the calculated value output data of the counting means with the previously set reference value data so as to finely adjust the oscillation frequency of the first voltage control oscillator so that the compared output data may stay within the given range.

14. A station selecting apparatus as defined in claim 12, where the phase continuous digital modulation signal is a MSK modulation signal.

15. A station selecting apparatus as defined in claim 14, where a frequency information detecting means for detecting the frequency information of the first intermediate frequency signal is a means for measuring the frequency of the first intermediate signal, the first frequency controlling means is a means for comparing the calculated value output data of the counting means with the previously set reference value data so as to finely adjust the oscillation frequency of the first voltage controlling oscillator so that the compared output data may stay within the given range.

16. A station selecting apparatus as defined in claim 14, further comprising a carrier reproducing circuit for reproducing the carrier of the second intermediate frequency signal so as to output the synchronizing detection signal of the carrier, the second frequency controlling means receives frequency information obtained by the frequency information detecting means, when the MSK modulation signal is inputted to the first frequency converting circuit, to finely adjust the oscillation frequency of the second voltage controlling oscillator so that the frequency of the second intermediate frequency signal may stay in a given frequency range; and, when the MSK modulation signal is not inputted to the first frequency converting circuit, to finely adjust the oscillation frequency of the second voltage controlling oscillator before the synchronizing detection signal is adapted to be outputted so that the frequency of the second intermediate frequency signal may stay within a given range.

17. A station selecting apparatus as defined in claim 16, where a frequency information detecting means for detecting the frequency information of the first intermediate frequency signal is a means for measuring the frequency of the first intermediate signal, the first frequency controlling means is a frequency controlling means for comparing the calculated value output data of the counting means with the previously set reference value data so as to finely adjust the oscillation frequency of the first voltage controlling oscillator so that the compared output data may stay within the given range.

18. A station selecting apparatus as defined in claim 1, where the modulation signal continued in carrier phase is an AM modulated AM modulation signal.

19. A station selecting apparatus comprising a frequency converting circuit for frequency-converting a modulation signal continued in a carrier phase or a digitally modulated digital modulation signal so as to respectively output the first intermediate frequency signal or the second intermediate frequency signal, a station selecting means provided with a voltage controlling oscillator for changing the oscillation frequency by the station selecting information so as to feed the local oscillation signal of the voltage controlling oscillator to the frequency converting circuit, a frequency information detecting means for detecting the frequency information of the first intermediate signal, a frequency information storing means for storing, preserving the frequency information obtained by the frequency information detecting means, a frequency controlling means, where a modulation signal continued in the carrier phase is frequency-converted by the frequency converting circuit, for receiving the frequency information obtained by the frequency information detecting means, when the first intermediate frequency signal is outputted, to finely adjust the oscillation frequency of the voltage controlling oscillator so that the frequency of the first intermediate frequency signal may stay within a given frequency range, and where a digitally modulated digital modulation signal is frequency-converted by the frequency converting circuit, for receiving the frequency information stored, preserved by the frequency information storing means, when the second intermediate signal is outputted, to finely adjust the oscillation frequency of the voltage controlling oscillator so that the frequency of the second intermediate frequency signal may stay in a given frequency range.

20. A station selecting apparatus as defined in claim 19, further comprising a carrier reproducing circuit for reproducing a carrier of the second intermediate frequency signal so as to output the synchronizing detection signal when the carrier has been reproduced, an oscillation frequency information storing means for storing, preserving the oscillation frequency information of the voltage controlling oscillator when the synchronizing detection signal is outputted, a frequency controlling means where the modulation signal continued in the carrier phase is frequency-converted by the frequency converting circuit, for receiving the frequency information obtained by the frequency information detecting means, when the first intermediate frequency signal is outputted, to finely adjust the oscillation frequency of the voltage controlling oscillator so that the frequency of the first intermediate frequency signal may stay within the given frequency range and, where the digitally modulated digital modulation signal is converted in frequency by the frequency converting circuit, for receiving the frequency information recorded, preserved by the frequency information storing means, when the second intermediate frequency signal is outputted, to finely adjust the oscillation frequency of the voltage controlling oscillator so that the frequency of the second intermediate frequency signal may stay within a given frequency range, and thereafter, the synchronizing detection signal may be outputted, a frequency controlling means for finely adjusting the oscillation frequency of the voltage controlling oscillator before the synchronizing detection signal is outputted, when the modulation signal continued in the carrier phase does not exist, the first intermediate frequency signal is not outputted, and the frequency information is not obtained by the frequency information detecting means, for receiving the oscillation frequency information of the voltage control oscillator stored, preserved by the oscillation frequency information storing means, after the synchronizing detection signal has been outputted, so as to finely adjust the oscillation frequency of the voltage control oscillator so that the frequency of the second intermediate frequency signal may stay in the given frequency control, and thereafter, the synchronising detecting signal may be outputted.

## Patentansprüche

1. Stationswähler mit einer Stationswahlschaltung für Trägerphasensequenz-Modulationssignale, der eine erste Frequenzwandlerschaltung zur Frequenzumwandlung von in einer Trägerphase fortgeführten Modulationssignalen enthält, um ein erstes Zwischenfrequenzsignals auszugeben;
mit einem ersten Stationswahlmittel, das einen ersten spannungsgesteuerten Oszillator zum Ändern der Oszillationsfrequenz durch Stationswahlinformationen und zum Zuführen des Oszillationssignals des ersten spannungsgesteuerten Oszillators an die erste Frequenzwandlerschaltung enthält;
mit Frequenzinformation-Erfassungsmitteln zum Erfassen der Frequenzinformationen des ersten Zwischenfrequenzsignals;
mit einem ersten Frequenzsteuermittel zum Empfangen der von den Frequenzinformation-Erfassungsmitteln erfaßten Frequenzinformationen zur Feineinstellung der Oszillationsfrequenz des ersten spannungsgesteuerten Oszillators, so daß die Frequenz des ersten Zwischenfrequenzsignals innerhalb des gegebenen Frequenzbereiches bleibt;
und mit einer Stationswahlschaltung für Digitalmodulationssignale, die eine zweite Frequenzwandlerschaltung zur Frequenzumwandlung des digital modulierten Digitalmodulationssignals und zur Ausgabe des zweiten Zwischenfrequenzsignals enthält;
mit einem zweiten Stationswahlmittel, das einen zweiten spannungsgesteuerten Oszillator zum Ändern der Oszillationsfrequenz durch Stationswahlinformationen und zum Zuführen des Oszillationssignals des zweiten spannungsgesteuerten Oszillators an die zweite Frequenzwandlerschaltung enthält;
mit einem zweiten Frequenzsteuermittel zum Empfangen von Frequenzinformationen, die von den Frequenzinformation-Erfassungsmitteln erfaßt wurden, zur Feineinstellung der Oszillationsfrequenz des zweiten spannungsgesteuerten Oszillators, so daß die Frequenz des zweiten Zwischenfrequenzsignals in dem gegebenen Frequenzbereich bleibt.

2. Stationswähler nach Anspruch 1, bei dem ein in der Trägerphase fortgeführtes Modulationssignal ein in der Frequenz moduliertes FM-Signal ist.

3. Stationswähler nach Anspruch 2, bei dem ein Frequenzinformation-Erfassungsmittel zum Erfassen der Frequenzinformation des ersten Zwischenfrequenzsignals ein Rechenmittel zum Ermitteln der Frequenz des ersten Zwischenfrequenzsignals ist;
bei dem das erste Frequenzsteuermittel Ausgangsdaten des Rechenmittels, die einen errechneten Wert darstellen, mit vorbestimmten Referenzwertdaten vergleicht, um die Oszillationsfrequenz des ersten spannungsgesteuerten Oszillators so fein einzustellen, daß die ausgegebenen Vergleichsdaten innerhalb eines gegebenen Bereiches bleiben.

4. Stationswähler nach Anspruch 2, bei dem ein Frequenzinformation-Erfassungsmittel zum Erfassen der Frequenzinformation des ersten Zwischenfrequenzsignals aus der FM-Demodulationsschaltung des ersten Zwischenfrequenzsignals eine PLL-Demodulationsschaltung bildet, um aus der Gleichstromkomponente eines FM-Demodulationssignals, das ein Ausgangssignal der FM-Demodulationsschaltung ist, die Mittenfrequenz zu erfassen;
bei der das erste Frequenzsteuermittel ein Mittel zum Vergleichen einer Gleichstromkomponente des FM-Demodulationssignals mit einer vorbestimmten Referenzspannung ist, um die Oszillationsfrequenz des ersten spannungsgesteuerten Oszillators so fein einzustellen, daß die zu vergleichenden Ausgangswerte innerhalb des gegebenen Bereiches bleiben.

5. Stationswähler nach Anspruch 2 mit einem C/N-Detektor zum Erfassen des C/N-Verhältnisses eines FM-Modulationssignals;
einem Frequenzinformation-Erfassungsmittel zum Erfassen der Frequenzinformation des ersten Zwischenfrequenzsignals, das die Frequenz des ersten Zwischenfrequenzsignals errechnet;
wobei das erste Frequenzsteuermittel die Referenzwertdaten entsprechend den vom C/N-Detektor erfaßten Daten für das C/N-Verhältnis einstellt, welche Referenzwertdaten mit den vom Rechenmittel ausgegebenen Daten für den errechneten Wert zu vergleichen sind, um eine Feineinstellung der Oszillatorfrequenz des ersten spannungsgesteuerten Oszillators so durchzuführen, daß die ausgegebenen, zu vergleichenden Daten bei einem Vergleich der vom Rechenmittel errechneten Daten mit den Referenzwertdaten innerhalb eines gegebenen Bereiches bleiben.

6. Stationswähler nach Anspruch 2 mit einer Trägerreproduktionsschaltung zum Reproduzieren des Trägers des zweiten Zwischenfrequenzsignals für die Ausgabe des synchronisierenden Detektorsignals des Trägers;
mit einem zweiten Frequenzsteuermittel, das die von den Frequenzinformation-Erfassungsmitteln erfaßte Frequenzinformation empfängt, wenn das FM-Modulationssignal der ersten Frequenzwandlerschaltung zugeleitet wird, um die Oszillationsfrequenz des zweiten spannungsgesteuerten Oszillators fein einzustellen, so daß die Frequenz des zweiten Zwischenfrequenzsignals in einem gegebenen Frequenzbereich bleibt, und, wenn das FM-Modulationssignal der ersten Frequenzwandlerschaltung nicht zugeleitet wird, die Oszillationsfrequenz des zweiten spannungsgesteuerten Oszillators vor der Ausgabebearbeitung des synchronisierenden Detektorsignals fein einzustellen, so daß die Frequenz des zweiten Zwischenfrequenzsignals innerhalb eines gegebenen Bereiches bleibt.

7. Stationswähler nach Anspruch 6, bei dem ein Frequenzinformation-Erfassungsmittel zum Erfassen der Frequenzinformation des ersten Zwischenfrequenzsignals die Frequenz des ersten Zwischenfrequenzsignals errechnet;
bei der das erste Frequenzsteuermittel ein Mittel zum Vergleichen der Ausgangsdaten für den errechneten Wert der Ziffern mit den vorbestimmten Referenzwertdaten zur Feineinstellung der Oszillationsfrequenz des ersten spannungsgesteuerten Oszillators ist, so daß die verglichenen Ausgangsdaten innerhalb eines gegebenen Bereiches bleiben.

8. Stationswähler nach Anspruch 6, bei dem ein Frequenzinformation-Erfassungsmittel zum Erfassen der Frequenzinformation des ersten Zwischenfrequenzsignals aus der FM-Demodulationsschaltung des ersten Zwischenfrequenzsignals eine Phasenregelkreisschaltung macht, so daß die Mittenfrequenz des ersten Zwischensignals aus der Gleichstromkomponente eines FM-Demodulationssignals der FM-Demodulationsschaltung erfaßt wird;
bei der das erste Frequenzsteuermittel ein Mittel zum Vergleichen einer Gleichstromkomponente des FM-Demodulationssignals mit der vorbestimmten Referenzspannung ist, so daß die Oszillationsfrequenz des ersten spannungsgesteuerten Oszillators fein eingestellt wird, damit der verglichene Ausgangswert innerhalb des gegebenen Bereiches bleibt.

9. Stationswähler nach Anspruch 6 mit einem C/N-Detektor zum Erfassen des C/N-Verhältnisses eines FM-Modulationssignals und
mit einem Frequenzinformation-Erfassungsmittel zum Erfassen der Frequenzinformation des ersten Zwischenfrequenzsignals, das zum Errechnen der Frequenz des ersten Zwischenfrequenzsignals ausgelegt ist,
mit einem ersten Frequenzsteuermittel, das zum Einstellen der Referenzwertdaten entsprechend den von dem C/N-Detektor erfaßten C/N-Verhältnisdaten ausgelegt ist, welche Referenzwertdaten mit den Ausgangsdaten für den errechneten Wert des Rechenmittels zu vergleichen sind, um die Oszillationsfrequenz des ersten spannungsgesteuerten Oszillators fein einzustellen, damit die zu vergleichenden Ausgangsdaten bei dem Vergleich der errechneten Ausgangsdaten des Rechenmittels mit den Referenzwertdaten innerhalb eines gegebenen Bereiches bleiben.

10. Stationswähler nach Anspruch 1, bei dem das in einer Trägerphase fortgeführte Modulationssignal einphasenkontinuierliches Digitalmodulationssignal ist.

11. Stationswähler nach Anspruch 10, bei dem ein Frequenzinformation-Erfassungsmittel zum Erfassen der Frequenzinformation des ersten Zwischenfrequenzsignals die Frequenz des ersten Zwischenfrequenzsignals mißt;
das erste Frequenzsteuermittel die Ausgangsdaten des errechneten Wertes der Zählmittel mit den vorbestimmten Referenzwertdaten vergleicht, so daß die Oszillationsfrequenz des ersten spannungsgesteuerten Oszillators fein eingestellt wird, damit die verglichenen Ausgangsdaten innerhalb des gegebenen Bereiches bleiben.

12. Stationswähler nach Anspruch 10 mit einer Trägerreproduktionsschaltung zum Reproduzieren des Trägers des zweiten Zwischenfrequenzsignals zur Ausgabe des synchronisierenden Detektorsignals des Trägers, wobei das zweite Frequenzsteuermittel Frequenzinformationen empfängt, die von dem Frequenzinformation-Erfassungsmittel erfaßt wurden, wenn das phasenkontinuierliche Digitalmodulationssignal in die erste Frequenzwandlerschaltung eingegeben wird, um die Oszillationsfrequenz des zweiten spannungsgesteuerten Oszillators fein einzustellen, damit die Frequenz des zweiten Zwischenfrequenzsignals in einem gegebenen Frequenzbereich bleibt,
und, wenn das phasenkontinuierliche Digitalmodulationssignal nicht in die erste Frequenzwandlerschaltung eingegeben wird, eine Feineinstellung der Oszillationsfrequenz des zweiten spannungsgesteuerten Oszillators durchzuführen, bevor das synchronisierende Detektorsignal für die Ausgabe bearbeitet wurde, so daß die Frequenz des zweiten Zwischenfrequenzsignals in einem gegebenen Bereich bleibt.

13. Stationswähler nach Anspruch 12, bei dem ein Frequenzinformation-Erfassungsmittel zum Erfassen der Frequenzinformationen des ersten Zwischenfrequenzsignals die Frequenz des ersten Zwischensignals mißt;
das erste Frequenzsteuermittel die Ausgangsdaten für den errechneten Wert des Zählmittels mit den vorbestimmten Referenzwertdaten vergleicht, so daß die Oszillationsfrequenz des ersten spannungsgesteuerten Oszillators fein eingestellt wird, damit die verglichenen Ausgangsdaten innerhalb des gegebenen Bereiches bleiben.

14. Stationswähler nach Anspruch 12, bei dem das phasenkontinuierliche Digitalmodulationssignal ein MSK-Modulationssignal ist.

15. Stationswähler nach Anspruch 14, bei dem ein Frequenzinformation-Erfassungsmittel zum Erfassen der Frequenzinformationen des ersten Zwischenfrequenzsignals die Frequenz des ersten Zwischensignals mißt;
das erste Frequenzsteuermittel die Ausgangsdaten für den errechneten Wert der Zählmittel mit den vorbestimmten Referenzwertdaten vergleicht, so daß die Oszillationsfrequenz des ersten spannungsgesteuerten Oszillators fein eingestellt wird, damit die verglichenen Ausgangsdaten innerhalb des gegebenen Bereiches bleiben.

16. Stationswähler nach Anspruch 14 mit einer Trägerreproduktionsschaltung zum Reproduzieren des Trägers des zweiten Zwischenfrequenzsignals zur Ausgabe des synchronisierenden Detektorsignals des Trägers;
mit zweiten Frequenzsteuermitteln, die die von dem Frequenzinformation-Erfassungsmittel erfaßten Frequenzinformationen empfangen, wenn das MSK-Modulationssignal in die erste Frequenzwandlerschaltung eingegeben wird, um die Oszillationsfrequenz des zweiten spannungsgesteuerten Oszillators fein einzustellen, damit die Frequenz des zweiten Zwischenfrequenzsignals in einem gegebenen Frequenzbereich bleibt, und,
wenn das MSK-Modulationssignal nicht in die erste Frequenzwandlerschaltung eingegeben wird, die Oszillationsfrequenz des zweiten spannungsgesteuerten Oszillators fein einzustellen, bevor das synchronisierende Detektorsignal für die Ausgabe bearbeitet wurde, so daß die Frequenz des zweiten Zwischenfrequenzsignals in einem gegebenen Bereich bleibt.

17. Stationswähler nach Anspruch 16, bei dem ein Frequenzinformation-Erfassungsmittel zum Erfassen der Frequenzinformationen des ersten Zwischenfrequenzsignals die Frequenz des ersten Zwischensignals mißt;
das erste Frequenzsteuermittel die Ausgangsdaten für den errechneten Wert der Zählmittel mit den vorbestimmten Referenzwertdaten vergleicht, so daß die Oszillationsfrequenz des ersten spannungsgesteuerten Oszillators fein eingestellt wird, damit die verglichenen Ausgangsdaten innerhalb des gegebenen Bereiches bleiben.

18. Stationswähler nach Anspruch 1, bei dem das in Trägerphase bleibende Modulationssignal ein amplitudenmoduliertes Signal ist.

19. Stationswähler mit einer Frequenzwandlerschaltung zum Umwandeln der Frequenz eines Modulationssignals, das in einer Trägerphase bleibt, oder eines digital modulierten Digitalmodulationssignals, um das erste bzw. zweite Zwischenfrequenzsignals auszugeben;
einem Stationswahlmittel, das einen spannungsgesteuerten Oszillator zum Ändern der Oszillationsfrequenz durch die Stationswahlinformationen enthält, um der Frequenzwandlerschaltung das Oszillationssignal des spannungsgesteuerten Oszillators zuzuführen;
einem Frequenzinformation-Erfassungsmittel zum Erfassen der Frequenzinformationen des ersten Zwischensignals;
einem Frequenzinformationsspeicher zum Speichern und Erhalten der von dem Frequenzinformation-Erfassungsmittel erhaltenen Frequenzinformationen;
einem Frequenzsteuermittel, das bewirkt, daß die Frequenzwandlerschaltung ein in der Trägerphase fortgeführtes Modulationssignal in seiner Frequenz verändert, um die von dem Frequenzinformation-Erfassungsmittel erfaßte Frequenzinformation zu empfangen, wenn das erste Zwischenfrequenzsignal ausgegeben wird, um die Oszillationsfrequenz des spannungsgesteuerten Oszillators fein einzustellen, damit die Frequenz des ersten Zwischenfrequenzsignals innerhalb eines gegebenen Frequenzbereiches bleibt, und
daß ein Digitalmodulationssignal von der Frequenzwandlerschaltung in seiner Frequenz verändert wird für dem Empfang der im Frequenzinformationsspeicher gespeicherten Frequenzinformation, wenn das zweite Zwischensignal ausgegeben wird, um die Oszillationsfrequenz des spannungsgesteuerten Oszillators fein einzustellen, damit die Frequenz des zweiten Zwischenfrequenzsignals in einem gegebenen Frequenzbereich bleibt.

20. Stationswähler nach Anspruch 19 mit einer Trägerreproduktionsschaltung zum Reproduzieren eines Trägers des zweiten Zwischenfrequenzsignals und Ausgeben des synchronisierenden Detektorsignals, wenn der Träger reproduziert wurde; mit einem Oszillationsfrequenzinformationsspeicher zum Speichern des Oszillationsfrequenzinformation des spannungsgesteuerten Oszillators, wenn das synchronisierende Detektorsignal ausgegeben wird;
einem Frequenzsteuermittel, das die Frequenzumwandlung des in der Trägerphase fortgeführten Modulationssignals durch die Frequenzwandlerschaltung bewirkt, um die von dem Frequenzinformation-Erfassungsmittel erfaßte Frequenzinformation zu empfangen, wenn das erste Zwischenfrequenzsignal ausgegeben wird, um die Oszillationsfrequenz des spannungsgesteuerten Oszillators fein einzustellen, damit die Frequenz des ersten Zwischenfrequenzsignals innerhalb des gegebenen Frequenzbereiches bleibt, und eine Frequenzumwandlung des Digitalmodulationssignals durch die Frequenzwandlerschaltung bewirkt, um die vom Frequenzinformationsspeicher gespeicherte Frequenzinformation zu empfangen, wenn das zweite Zwischenfrequenzsignal ausgegeben wird, um die Oszillationsfrequenz des spannungsgesteuerten Oszillators fein einzustellen, damit die Frequenz des zweiten Zwischenfrequenzsignals in einem gegebenen Frequenzbereich bleibt und danach das synchronisierende Detektorsignals ausgegeben werden kann;
mit einem Frequenzsteuermittel zum Feineinstellen der Oszillationsfrequenz des spannungsgesteuerten Oszillators bevor das synchronisierende Detektorsignals ausgegeben wird, wobei, wenn das in der Trägerphase bleibende Modulationssignal nicht vorhanden ist, das erste Zwischenfrequenzsignals nicht ausgegeben wird, und die Frequenzinformation nicht von dem Frequenzinformation-Erfassungsmittel erfaßt wird, um die im Oszillationsfrequenzinformationsspeicher gespeicherte Oszillationsfrequenzinformation des spannungsgesteuerten Oszillators zu empfangen, nachdem das synchronisierende Detektorsignal ausgegeben wurde, um die Oszillationsfrequenz des spannungsgesteuerten Oszillators fein einzustellen, damit die Frequenz des zweiten Zwischenfrequenzsignals in der gegebenen Frequenzsteuerung bleibt und danach das synchronisierende Detektorsignal ausgegeben werden kann.

## Revendications

1. Dispositif de sélection de station comprenant un circuit de sélection de station destiné à l'utilisation d'un signal de modulation de séquence de phases de porteuse, qui comprend un premier circuit de conversion de fréquence destiné à convertir en fréquence des signaux de modulation entretenus dans une phase de la porteuse de façon à sortir un premier signal à fréquence intermédiaire, un premier moyen de sélection de station muni d'un premier oscillateur commandé en tension destiné à modifier la fréquence d'oscillation par les informations de sélection de station, et à appliquer au premier circuit de conversion de fréquence le signal d'oscillation locale du premier oscillateur commandé en tension, un moyen de détection d'informations de fréquence destiné à détecter les informations de fréquence du premier signal à fréquence intermédiaire, un premier moyen de commande de fréquence destiné à recevoir des informations de fréquence obtenues par le moyen de détection d'informations de fréquence, à régler avec précision la fréquence d'oscillation du premier oscillateur commandé en tension de sorte que la fréquence du premier signal à fréquence intermédiaire puisse rester à l'intérieur de la plage de fréquences donnée, et d'un circuit de sélection de station destiné à l'utilisation d'un signal de modulation numérique, qui comprend un second circuit de conversion de fréquence destiné à convertir en fréquence le signal de modulation numérique modulé de façon numérique, de façon à sortir le second signal à fréquence intermédiaire, un second moyen de sélection de station muni d'un second oscillateur commandé en tension, destiné à faire varier la fréquence d'oscillation par les informations de sélection de station et à appliquer au second circuit de conversion de fréquence le signal d'oscillation locale du second oscillateur commandé en tension, un second moyen de commande de fréquence destiné à recevoir des informations de fréquence obtenues par le moyen de détection de formation de fréquence, à régler avec précision la fréquence d'oscillation du second oscillateur commandé en tension de sorte que la fréquence du second signal à fréquence intermédiaire puisse rester dans la plage de fréquences donnée.

2. Dispositif de sélection de station selon la revendication 1, dans lequel un signal de modulation entretenu dans la phase de porteuse est un signal de modulation de fréquence modulé par une modulation de fréquence (FM).

3. Dispositif de sélection de station selon la revendication 2, dans lequel un moyen de détection d'informations de fréquence destiné à détecter les informations de fréquence du premier signal à fréquence intermédiaire est un moyen de calcul destiné à compter la fréquence du premier signal à fréquence intermédiaire, le premier moyen de commande de fréquence compare des données de sortie de la valeur calculée du moyen de calcul à des données de valeur de référence précédemment établies de façon à régler avec précision la fréquence d'oscillation du premier oscillateur commandé en tension de sorte que les données de sortie de comparaison puissent rester à l'intérieur d'une plage donnée.

4. Dispositif de sélection de station selon la revendication 2, dans lequel un moyen de détection d'informations de fréquence destiné à détecter les informations de fréquence du premier signal à fréquence intermédiaire est un moyen destiné à établir le circuit de démodulation du premier signal à fréquence intermédiaire en signal de démodulation à boucle à verrouillage de phase (PLL) de façon à détecter la fréquence centrale du premier signal intermédiaire à partir de la composante en courant continu d'un signal de démodulation de modulation de fréquence qui est un signal de sortie du circuit de démodulation de la modulation de fréquence, le premier moyen de commande de fréquence est un moyen destiné à comparer une composante en courant continu du signal de démodulation de la modulation de fréquence à la tension de référence précédemment établie, de façon à régler avec précision la fréquence d'oscillation du premier oscillateur commandé en tension de sorte que les valeurs de sortie comparées puissent rester à l'intérieur de la plage donnée.

5. Dispositif de sélection de station selon la revendication 2, comprenant en outre un moyen de détection de rapport porteuse/bruit destiné à détecter le rapport porteuse/bruit d'un signal à modulation de fréquence, un moyen de détection d'informations de fréquence destiné à détecter les informations de fréquence du premier signal à fréquence intermédiaire qui est un moyen destiné à calculer la fréquence du premier signal à fréquence intermédiaire, et dans lequel le premier moyen de commande de fréquence est un moyen destiné à établir, conformément aux données du rapport porteuse/bruit obtenues par le moyen de détection de rapport porteuse/bruit, les données de valeur de référence à comparer avec les données de sortie de la valeur calculée du moyen de calcul de façon à régler avec précision la fréquence d'oscillation du premier oscillateur commandé en tension de sorte que les données de sortie de la comparaison au cours de laquelle les données de sortie calculées du moyen de calcul sont comparées aux données de la valeur de référence, puissent rester à l'intérieur d'une plage donnée.

6. Dispositif de sélection de station selon la revendication 2, comprenant en outre un circuit de reproduction de la porteuse destiné à reproduire la porteuse du second signal à fréquence intermédiaire de façon à sortir le signal de détection de synchronisation de la porteuse, le second moyen de commande de fréquence reçoit les informations de fréquence obtenues par le moyen de détection d'informations de fréquence, lorsque le signal de modulation de fréquence est entré dans le premier circuit de conversion de fréquence, afin de régler avec précision la fréquence d'oscillation du second oscillateur commandé en tension de sorte que la fréquence du second signal à fréquence intermédiaire puisse rester dans une plage de fréquences donnée, et lorsque le signal à modulation de fréquence n'est pas entré dans le premier circuit de conversion de fréquence, pour régler avec précision la fréquence d'oscillation du second oscillateur commandé en tension avant que le signal de détection de synchronisation soit adapté pour être sorti, de sorte que la fréquence du second signal à fréquence intermédiaire puisse rester à l'intérieur d'une plage donnée.

7. Dispositif de sélection de station selon la revendication 6, dans lequel un moyen de détection d'informations de fréquence destiné à détecter les informations de fréquence du premier signal à fréquence intermédiaire est un moyen destiné à calculer la fréquence du premier signal à fréquence intermédiaire, le premier moyen de commande de fréquence est un moyen destiné à comparer les données de sortie de la valeur calculée des chiffres aux données de valeur de référence établies précédemment de façon à régler avec précision la fréquence d'oscillation du premier oscillateur commandé en tension de sorte que les données de sortie comparées puissent rester à l'intérieur de la plage donnée.

8. Dispositif de sélection de station selon la revendication 6, dans lequel un moyen de détection d'informations de fréquence destiné à détecter les informations de fréquence du premier signal à fréquence intermédiaire est un moyen destiné à établir le circuit de démodulation de la modulation de fréquence du premier signal à fréquence intermédiaire sous forme d'un circuit de démodulation à boucle à verrouillage de phase de façon à détecter la fréquence centrale du premier signal intermédiaire d'après la composante en courant continu d'un signal de démodulation de la modulation de fréquence, lequel est un signal sorti du circuit de démodulation de la modulation de fréquence, le premier moyen de commande de fréquence est un moyen destiné à comparer une composante en courant continu du signal de démodulation de la modulation de fréquence à la tension de référence établie précédemment de façon à régler avec précision la fréquence d'oscillation du premier oscillateur commandé en tension de sorte que la valeur de sortie comparée puisse rester à l'intérieur de la plage donnée.

9. Dispositif de sélection de station selon la revendication 6, comprenant en outre un moyen de détection de rapport porteuse/bruit destiné à détecter le rapport porteuse/bruit d'un signal de modulation de fréquence, et dans lequel un moyen de détection d'informations de fréquence destiné à détecter les informations de fréquence du premier signal à fréquence intermédiaire est un moyen destiné à calculer la fréquence du premier signal à fréquence intermédiaire, le premier moyen de commande de fréquence est un moyen destiné à établir, conformément aux données du rapport porteuse/bruit obtenues par le moyen de détection de rapport porteuse/bruit, les données de la valeur de référence à comparer aux données de sortie de la valeur calculée du moyen de calcul de façon à régler avec précision la fréquence d'oscillation du premier oscillateur commandé en tension de sorte que les données de sortie de la comparaison au cours de laquelle les données de sortie calculées du moyen de calcul sont comparées aux données de la valeur de référence, puissent rester à l'intérieur d'une plage donnée.

10. Dispositif de sélection de station selon la revendication 1, dans lequel le signal de modulation entretenu dans une phase de la porteuse est un signal de modulation numérique à phase entretenue.

11. Dispositif de sélection de station selon la revendication 10, dans lequel un moyen de détection d'informations de fréquence destiné à détecter les informations de fréquence du premier signal à fréquence intermédiaire est un moyen destiné à mesurer la fréquence du premier signal à fréquence intermédiaire, le premier moyen de commande de fréquence est un moyen destiné à comparer les données de sortie de la valeur calculée du moyen de comptage aux données de la valeur de référence établie précédemment de façon à régler avec précision la fréquence d'oscillation du premier oscillateur commandé en tension de sorte que les données de sortie comparées puissent rester à l'intérieur de la plage donnée.

12. Dispositif de sélection de station selon la revendication 10, comprenant en outre un circuit de reproduction de la porteuse destiné à reproduire la porteuse du second signal à fréquence intermédiaire de façon à sortir le signal de détection de synchronisation de la porteuse, le second moyen de commande de fréquence reçoit les informations de fréquence obtenues par le moyen de détection d'informations de fréquence, lorsque le signal de modulation numérique à phase entretenue est entré dans le premier circuit de conversion de fréquence, afin de régler avec précision la fréquence d'oscillation du second oscillateur commandé en tension de sorte que la fréquence du second signal à fréquence intermédiaire puisse rester dans une plage de fréquences donnée, et lorsque le signal de modulation numérique à phase entretenue n'est pas entré dans le premier circuit de conversion de fréquence, pour régler avec précision la fréquence d'oscillation du second oscillateur commandé en tension avant que le signal de détection de synchronisation soit adapté pour être sorti de sorte que la fréquence du second signal à fréquence intermédiaire puisse rester à l'intérieur d'une plage donnée.

13. Dispositif de sélection de station selon la revendication 12, dans lequel un moyen de détection d'informations de fréquence destiné à détecter les informations de fréquence du premier signal à fréquence intermédiaire est un moyen destiné à mesurer la fréquence du premier signal intermédiaire, le premier moyen de commande de fréquence est un moyen de commande de fréquence destiné à comparer les données de sortie de la valeur calculée du moyen de comptage aux données de la valeur de référence établie précédemment de façon à régler avec précision la fréquence d'oscillation du premier oscillateur commandé en tension de sorte que les données de sortie comparées puissent rester à l'intérieur de la plage donnée.

14. Dispositif de sélection de station selon la revendication 12, dans lequel le signal de modulation numérique à phase entretenue est un signal à modulation à déplacement minimal (MSK).

15. Dispositif de sélection de station selon la revendication 14, dans lequel un moyen de détection d'informations de fréquence destiné à détecter les informations de fréquence du premier signal à fréquence intermédiaire est un moyen destiné à mesurer la fréquence du premier signal intermédiaire, le premier moyen de commande de fréquence est un moyen destiné à comparer les données de sortie de la valeur calculée du moyen de comptage aux données de la valeur de référence établies précédemment de façon à régler avec précision la fréquence d'oscillation du premier oscillateur commandé en tension de sorte que les données de sortie comparées puissent rester à l'intérieur de la plage donnée.

16. Dispositif de sélection de station selon la revendication 14, comprenant en outre un circuit de reproduction de la porteuse destiné à reproduire la porteuse du second signal à fréquence intermédiaire de façon à sortir le signal de détection de synchronisation de la porteuse, le second moyen de commande de fréquence reçoit des informations de fréquence obtenues par le moyen de détection d'informations de fréquence, lorsque le signal de modulation à déplacement minimal (MSK) est entré dans le premier circuit de conversion de fréquence, afin de régler avec précision la fréquence d'oscillation du second oscillateur commandé en tension de sorte que la fréquence du second signal à fréquence intermédiaire puisse rester dans une plage de fréquences donnée, et, lorsque le signal de modulation à déplacement minimal (MSK) n'est pas entré dans le premier circuit de conversion de fréquence, pour régler avec précision la fréquence d'oscillation du second oscillateur commandé en tension avant que le signal de détection de synchronisation soit adapté pour être sorti de façon à ce que la fréquence du second signal à fréquence intermédiaire puisse rester à l'intérieur d'une plage donnée.

17. Dispositif de sélection de station selon la revendication 16, dans lequel un moyen de détection d'informations de fréquence destiné à détecter les informations de fréquence du premier signal à fréquence intermédiaire est un moyen destiné à mesurer la fréquence du premier signal intermédiaire, le premier moyen de commande de fréquence est un moyen de commande de fréquence destiné à comparer les données de sortie de la valeur calculée du moyen de comptage aux données de valeur de référence établies précédemment, de façon à régler avec précision la fréquence d'oscillation du premier oscillateur commandé en tension de sorte que les données de sortie comparées puissent rester à l'intérieur de la plage donnée.

18. Dispositif de sélection de station selon la revendication 1, dans lequel le signal de modulation entretenu dans la phase de la porteuse est un signal de modulation d'amplitude modulé par modulation d'amplitude.

19. Dispositif de sélection de station comprenant un circuit de conversion de fréquence destiné à convertir en fréquence un signal de modulation entretenu dans la phase de la porteuse ou bien un signal de modulation numérique modulé de façon numérique, de façon à sortir respectivement le premier signal à fréquence intermédiaire ou le second signal à fréquence intermédiaire, un moyen de sélection de station muni d'un oscillateur commandé en tension destiné à modifier la fréquence d'oscillation par les informations de sélection de station de façon à appliquer le signal d'oscillation locale de l'oscillateur commandé en tension au circuit de conversion de fréquence, un moyen de détection d'informations de fréquence destiné à détecter les informations de fréquence du premier signal intermédiaire, un moyen de mémorisation d'informations de fréquence destiné à mémoriser, en les conservant, les informations de fréquence obtenues par le moyen de détection d'informations de fréquence, un moyen de commande de fréquence, où un signal de modulation entretenu dans la phase de la porteuse est converti en fréquence par le circuit de conversion de fréquence, afin de recevoir des informations de fréquence obtenues par le moyen de détection d'informations de fréquence, lorsque le premier signal à fréquence intermédiaire est sorti, afin de régler avec précision la fréquence d'oscillation de l'oscillateur commandé en tension de sorte que la fréquence du premier signal à fréquence intermédiaire puisse rester à l'intérieur d'une plage de fréquences donnée, et où un signal de modulation numérique modulé de façon numérique est converti en fréquence par le circuit de conversion de fréquence, afin de recevoir les informations de fréquence mémorisées, conservées par le moyen de mémorisation de fréquence, lorsque le second signal intermédiaire est sorti, afin de régler avec précision la fréquence d'oscillation de l'oscillateur commandé en tension de sorte que la fréquence du second signal à fréquence intermédiaire puisse rester dans une plage de fréquences donnée.

20. Dispositif de sélection de station selon la revendication 19, comprenant en outre un circuit de reproduction de porteuse destiné à reproduire une porteuse du second signal à fréquence intermédiaire de façon à sortir le signal de détection de synchronisation lorsque la porteuse a été reproduite, un moyen de mémorisation d'informations de fréquence d'oscillation destiné à mémoriser, en les conservant, les informations de fréquence d'oscillation de l'oscillateur commandé en tension lorsque le signal de détection de synchronisation est sorti, un moyen de commande de fréquence où le signal de modulation entretenu dans la phase de la porteuse est converti en fréquence par le circuit de conversion de fréquence, afin de recevoir les informations de fréquence obtenues par le moyen de détection d'informations de fréquence, lorsque le premier signal à fréquence intermédiaire est sorti, afin de régler avec précision la fréquence d'oscillation de l'oscillateur commandé en tension de sorte que la fréquence du premier signal à fréquence intermédiaire puisse rester à l'intérieur de la plage de fréquences donnée, et, lorsque le signal de modulation numérique modulé de façon numérique est converti en fréquence par le circuit de conversion de fréquence, destiné à recevoir les informations de fréquence enregistrées, conservées par le moyen de mémorisation d'informations de fréquence, lorsque le second signal à fréquence intermédiaire est sorti, afin de régler avec précision la fréquence d'oscillation de l'oscillateur commandé en tension de sorte que la fréquence du second signal à fréquence intermédiaire puisse rester à l'intérieur d'une plage de fréquences donnée, et ensuite le signal de détection de synchronisation peut être sorti, un moyen de commande de fréquence destiné à régler avec précision la fréquence d'oscillation de l'oscillateur commandé en tension avant que le signal de détection de synchronisation soit sorti, lorsque le signal de modulation entretenu dans la phase de la porteuse n'existe pas, le premier signal à fréquence intermédiaire n'est pas sorti, et les informations de fréquence ne sont pas obtenues par le moyen de détection d'informations de fréquence, pour recevoir les informations de fréquence d'oscillation de l'oscillateur commandé en tension mémorisées, conservées par le moyen de mémorisation d'informations de fréquence d'oscillation, après que le signal de détection de synchronisation a été sorti, de façon à régler avec précision la fréquence d'oscillation de l'oscillateur commandé en tension de sorte que la fréquence du second signal à fréquence intermédiaire puisse rester dans la commande de fréquence donnée, et qu'ensuite, le signal de détection de synchronisation puisse être sorti.
